# EUROPEAN PATENT APPLICATION

(11) **EP 4 727 098 A1**
(43) Date of publication of application: **15.04.2026**
(21) Application number: 24840093.9
(22) Date of filing: 10.07.2024
(51) Int. Cl.: H04M 1/02, H05K 1/14

(54) **FOLDABLE ELECTRONIC DEVICE COMPRISING FLEXIBLE PRINTED CIRCUIT BOARD**

(30) Priority: 10.07.2023 KR 20230089165; 25.08.2023 KR 20230112197
(71) Applicant: Samsung Electronics Co., Ltd., Suwon-si, Gyeonggi-do 16677 (KR)
(72) Inventor: PARK, Honjeong, Suwon-si, Gyeonggi-do 16677 (KR); KIM, Yongwon, Suwon-si, Gyeonggi-do 16677 (KR); JUNG, Youngjin, Suwon-si, Gyeonggi-do 16677 (KR)
(74) Representative: Gulde & Partner
(86) International application number: PCT/KR2024/009870
(87) International publication number: WO 2025/014283

(57) **Abstract**

According to an exemplary embodiment of the present disclosure, the provided foldable electronic device comprises: a foldable housing including a first housing, a second housing and a hinge portion for connecting the first housing and the second housing; a flexible printed circuit board extending across the hinge portion; a first support member for connecting the flexible printed circuit board to the first housing; and a second support member for connecting the flexible printed circuit board to the second housing, wherein: the hinge portion includes a first plate and a second plate, and is formed such that the first plate and the second plate face each other when the foldable housing is switched from an unfolded state to a folded state; the first support member is positioned between the first plate and the first housing, and is arranged in a first recess formed in the first housing; a first fixing region of the flexible printed circuit board is arranged between the first support member and the first housing so as to surround the first support member in the first recess; the second support member is arranged between the second plate and the second housing, and is arranged in a second recess formed in the second housing; and a second fixing region of the flexible printed circuit board is arranged between the second support member and the second housing so as to surround the second support member in the second recess.

## Description

### [Technical Field]

The disclosure relates to a foldable electronic device including a flexible printed board.

### [Background Art]

A foldable electronic device may include a flexible printed circuit board (FPCB) positioned in an internal space of a foldable electronic device across a folding portion.

The information described above may be provided as the related art for the purpose of enhancing the understanding of the present disclosure. No assertion or determination is made with respect to the applicability of any of the above-mentioned as the prior art related to the present disclosure.

### [Disclosure of Invention]

### [Technical Problem]

A flexible printed circuit board may include a bendable area corresponding to a folding portion of a foldable electronic device. The bendable area may be deformed in response to a transition between an unfolded state and a folded state of the foldable electronic device. The bendable area is required to be disposed in a shape in which bending stress may be reduced. However, in case that a length of the bendable area needs to be increased to reduce interference with constituent elements included in the folding portion of the foldable electronic device, there may be a limitation in disposing the bendable area in a shape in which bending stress may be reduced in a limited space.

Various embodiments of the present disclosure provide a foldable electronic device including a flexible printed circuit board capable of being disposed in a stable shape in which bending stress may be reduced. Various embodiments of the present disclosure are provided to solve or at least mitigate the above-mentioned problems.

Technical problems to be solved by the present disclosure are not limited to the above-mentioned technical problems, and other technical problems, which are not mentioned above, may be understood from the following descriptions by those skilled in the art to which the present disclosure pertains.

### [Solution to Problem]

According to the exemplary embodiment of the present disclosure, a foldable electronic device is provided, and the foldable electronic device includes a foldable housing, a flexible printed circuit board, a first support member, and/or a second support member. The foldable housing includes a first housing, a second housing, and a hinge portion configured to connect the first housing and the second housing. The flexible printed circuit board extends across the hinge portion. The first support member is configured to connect the first housing to the flexible printed circuit board. The second support member is configured to connect the second housing to the flexible printed circuit board. The hinge portion includes a first plate and a second plate. The hinge portion is configured such that the first plate and the second plate face each other when foldable housing is changed from an unfolded state to a folded state. The first support member is positioned between the first plate and the first housing and is disposed in a first recess formed on the first housing. A first fixing area of the flexible printed circuit board is disposed between the first support member and the first housing to surround the first support member in the first recess. The second support member is positioned between the second plate and the second housing and is disposed in a second recess formed on the second housing. A second fixing area of the flexible printed circuit board is disposed between the second support member and the second housing to surround the second support member in the second recess.

According to the exemplary embodiment of the present disclosure, a foldable electronic device is provided, and the foldable electronic device includes a foldable housing, a flexible display module, a flexible printed circuit board, a first support member, and/or a second support member. The foldable housing includes a first housing, a second housing, and a hinge portion configured to connect the first housing and the second housing. The flexible display module is disposed in the foldable housing. The flexible display module includes a first display area disposed in the first housing, a second display area disposed in the second housing, and a third display area configured to extend the first display area and the second display area. In the folded state of the foldable housing, the first display area and the second display area face each other, and the third display area is curved. The flexible printed circuit board extends across the hinge portion. The first support member is configured to connect the first housing to the flexible printed circuit board. The second support member is configured to connect the second housing to the flexible printed circuit board. The hinge portion includes a first plate and a second plate. The hinge portion is configured such that the first plate and the second plate support the third display area so that the third display area is flat in the unfolded state of the foldable housing. The hinge portion is configured such that the first plate and the second plate face each other with the third display area interposed therebetween in the folded state of the foldable housing. The first support member is positioned between the first plate and the first housing and is disposed in a first recess formed on the first housing. A first fixing area of the flexible printed circuit board is disposed between the first support member and the first housing to surround the first support member in the first recess. The second support member is positioned between the second plate and the second housing and is disposed in a second recess formed on the second housing. A second fixing area of the flexible printed circuit board is disposed between the second support member and the second housing to surround the second support member in the second recess.

### [Advantageous Effects of Invention]

According to the foldable electronic device including the flexible printed circuit board according to the various embodiments of the disclosure, the flexible printed circuit board is disposed in a stable shape in which bending stress may be reduced, which may reduce or prevent damage to the flexible printed circuit board.

Other effects, which may be obtained or expected by various embodiments of the present disclosure, will be directly or implicitly disclosed in the detailed description on the embodiments of the present disclosure.

### [Brief Description of Drawings]

The above and other aspects, features, and advantages of certain embodiments of the disclosure will be more apparent from the following descriptiontaken in conjuction with the accompanying drawings.
FIG. 1 is a view illustrating appearances of a foldable electronic device in an unfolded state according to an embodiment of the disclosure;
FIG. 2 is a view illustrating appearances of a foldable electronic device in a folded state according to an embodiment of the disclosure;
FIG. 3 is a cross-sectional view of a foldable electronic device taken along line D-D' in FIG. 1 according to an embodiment of the disclosure;
FIG. 4 is an exploded perspective view of a part of a foldable electronic device in an unfolded state according to an embodiment of the disclosure;
FIG. 5 is a view illustrating a part of a foldable electronic device in an unfolded state according to an embodiment of the disclosure;
FIG. 6 is an exploded perspective view of a part of a foldable electronic device in an unfolded state according to an embodiment of the disclosure;
FIG. 7 is a perspective view of a part of a foldable electronic device in an unfolded state according to an embodiment of the disclosure;
FIG. 8 is a view illustrating a part of a foldable electronic device in an unfolded state according to an embodiment of the disclosure;
FIG. 9 is an exploded perspective view of a part of a foldable electronic device in an unfolded state according to an embodiment of the disclosure;
FIG. 10 is a view illustrating a part of a foldable electronic device in an unfolded state according to an embodiment of the disclosure;
FIGS. 11, 12, and 13 are cross-sectional perspective views of a part of a foldable electronic device taken along line E-E' in FIG. 9 according to various embodiments of the disclosure.
FIG. 14 is a cross-sectional view of a part of a foldable electronic device taken along line E-E' in FIG. 9 according to an embodiment of the disclosure;
FIG. 15 is a cross-sectional view of a part of a foldable electronic device in a folded state according to an embodiment of the disclosure; and
FIG. 16 is a view illustrating operations of connecting a flexible printed circuit board to a first support plate and a second support plate according to an embodiment of the disclosure.

Throughout the drawings, it should be noted that like reference numbers are used to depict the same or similar elements, features, and structures.

### [Mode for the Invention]

The following description with reference to the accompanying drawings is provided to assist in a comprehensive understanding of various embodiments of the disclosure as defined by the claims and their equivalents. It includes various specific details to assist in that understanding but these are to be regarded as merely exemplary. Accordingly, those of ordinary skill in the art will recognize that various changes and modifications of the various embodiments described herein can be made without departing from the scope and spirit of the disclosure. In addition, descriptions of well-known functions and constructions may be omitted for clarity and conciseness.

The terms and words used in the following description and claims are not limited to the bibliographical meanings, but, are merely used by the inventor to enable a clear and consistent understanding of the disclosure. Accordingly, it should be apparent to those skilled in the art that the following description of various embodiments of the disclosure is provided for illustration purpose only and not for the purpose of limiting the disclosure as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

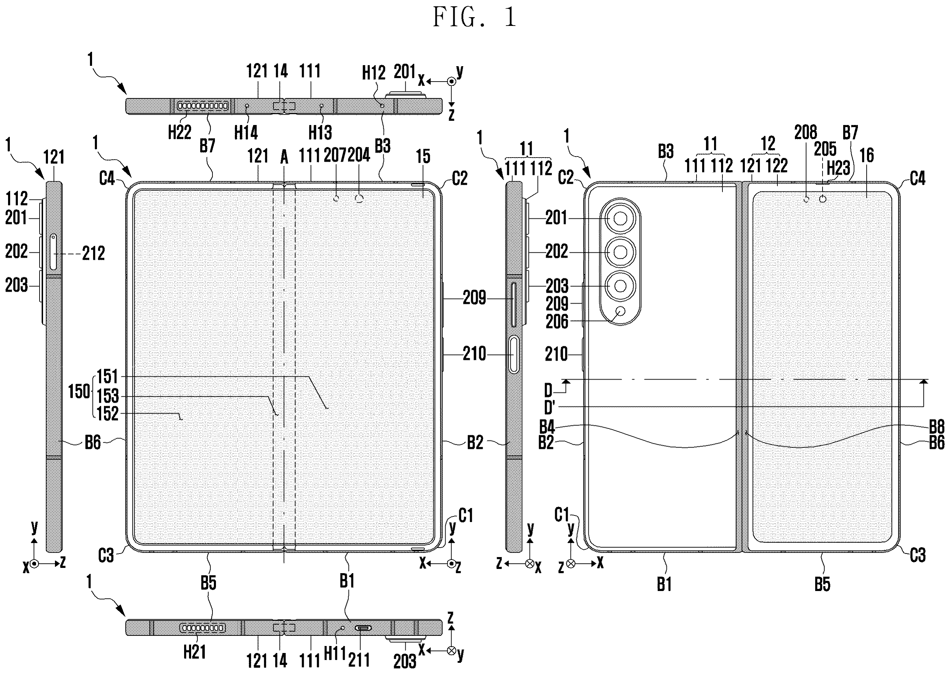

FIG. 1 is a view illustrating appearances of a foldable electronic device in an unfolded state (also referred to as a flat state) according to an embodiment of the disclosure.

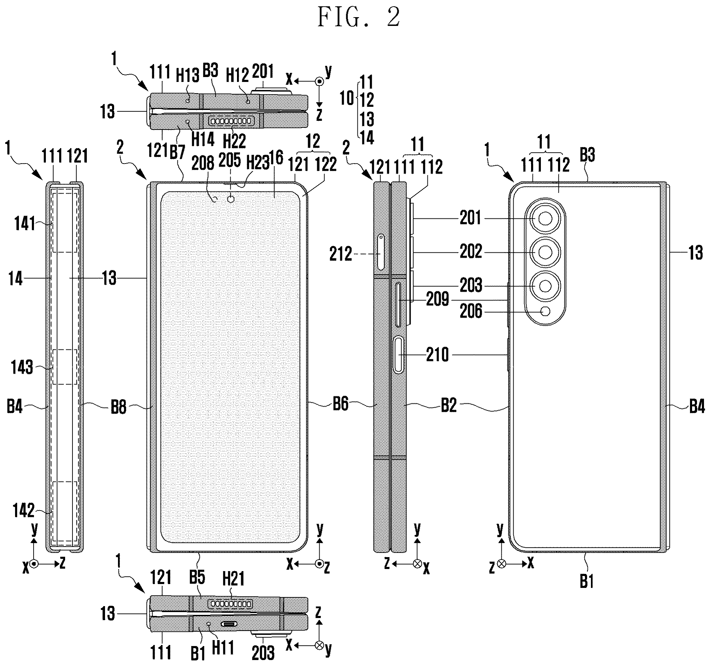

FIG. 2 is a view illustrating appearances of a foldable electronic device in a folded state (also referred to as a folding state) according to an embodiment of the disclosure.

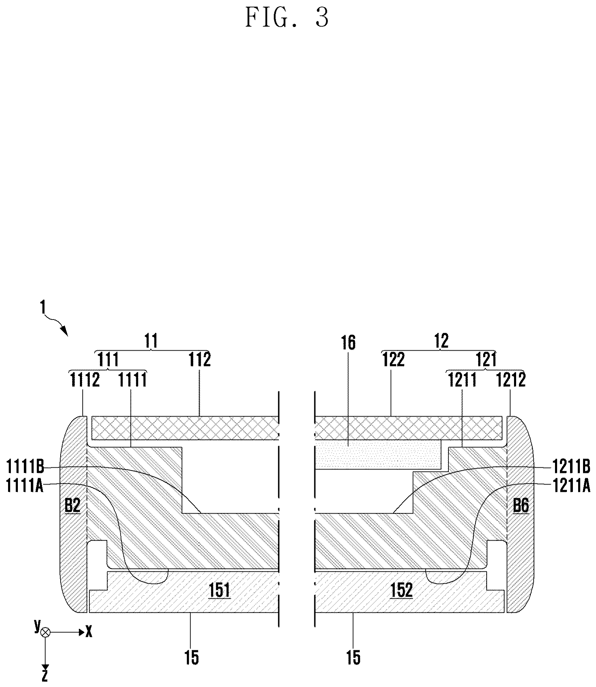

FIG. 3 is a cross-sectional view of a foldable electronic device taken along line D-D' in FIG. 1 according to an embodiment of the disclosure.

Referring FIGS. 1, 2, and 3, the foldable electronic device 1 may include a foldable housing 10, a first display module 15, a second display module 16, a first camera module 201, a second camera module 202, a third camera module 203, a fourth camera module 204, a fifth camera module 205, a light-emitting module 206, a first sensor module 207, a second sensor module 208, a first sound input module (not illustrated separately), a second sound input module (not illustrated separately), a third sound input module (not illustrated separately), a fourth sound input module (not illustrated separately), a first sound output module (not illustrated separately), a second sound output module (not illustrated separately), a third sound output module (not illustrated separately), a key input module, a first connection terminal 211, and/or a second connection terminal 212.

According to the embodiment of the disclosure, the unfolded state and the folded state of the foldable electronic device 1 may be provided substantially by the foldable housing 10. The 'unfolded state of the foldable electronic device 1' and the 'unfolded state of the foldable housing 10' disclosed in the disclosure may be interpreted as being substantially identical to each other. The 'folded state of the foldable electronic device 1' and the 'folded state of the foldable housing 10' disclosed in the disclosure may be interpreted as being substantially identical to each other.

According to the embodiment of the disclosure, the foldable housing 10 may include a first housing (also referred to as a first housing part or a first housing structure) 11, a second housing (also referred to as a second housing part or a second housing structure) 12, a hinge housing 13, and/or a hinge portion 14. The first housing 11 and the second housing 12 may be connected by the hinge portion 14. The first housing 11 and the second housing 12 may rotate relative to each other about the hinge portion 14. For example, the hinge portion 14 may include one or more hinge modules (also referred to as hinge assemblies) (e.g., a first hinge module 141, a second hinge module 142, and/or a third hinge module 143).

According to the embodiment of the disclosure, the first display module 15 may be disposed in the foldable housing 10. For example, the first display module 15 may include a flexible display module (also referred to as a flexible display) or a foldable display module (also referred to as a foldable display) that may be deformed in response to a transition between the unfolded state and the folded state of the foldable electronic device 1.

According to the embodiment of the disclosure, the first display module 15 may include a display area 150. The display area 150 may include an active area or a screen area in which images may be displayed based on electrical signals. The display area 150 may include a first display area 151 corresponding to the first housing 11, a second display area 152 corresponding to the second housing 12, and a third display area 153 corresponding to the hinge portion 14. The third display area 153 may extend the first display area 151 and the second display area 152.

According to the embodiment of the disclosure, the first display area 151 may be disposed in the first housing 11. A shape of the first display area 151 may be maintained by being supported by the first housing 11. For example, the first display area 151 may be supported by the first housing 11 and provided (or formed) substantially flat.

According to the embodiment of the disclosure, the second display area 152 may be disposed in the second housing 12. A shape of the second display area 152 may be maintained by being supported by the second housing 12. For example, the second display area 152 may be supported by the second housing 12 and provided (or formed) substantially flat.

According to the embodiment of the disclosure, the third display area 153 may be positioned to correspond to the hinge portion 14. When the foldable electronic device 1 is changed between the unfolded state and the folded state, the third display area 153 may be deformed in response to a relative position between the first display area 151 and the second display area 152. In the unfolded state of the foldable electronic device 1, the third display area 153 may be disposed substantially flat. In the folded state of the foldable electronic device 1, the third display area 153 may be disposed in a bent shape. The unfolded state of the foldable electronic device 1 may be defined or interpreted as a state in which the third display area 153 is disposed flat. The folded state of the foldable electronic device 1 may be defined or interpreted as a state in which the third display area 153 is disposed in a bent shape.

According to the embodiment of the disclosure, in the unfolded state of the foldable electronic device 1, the first display area 151 and the second display area 152 may define an angle of about 180 degrees, and the display area 150 may be provided (or disposed) in a substantially flat shape. In the unfolded state of the foldable electronic device 1, the third display area 153 may be disposed flat by means of a relative position between the first display area 151 disposed in the first housing 11 and the second display area 152 disposed in the second housing 12. In the unfolded state of the foldable electronic device 1, the third display area 153 may be pulled from two opposite sides by the first display area 151 and the second display area 152, and a pulling force may be provided to dispose the third display area 153 flat and reduce damage to the third display area 153. In the unfolded state of the foldable electronic device 1, the third display area 153 is pulled by the first display area 151 and the second display area 152, such that stress may be reduced, and the third display area 153 may be provided (or formed) to have an extended width so that the third display area 153 may be disposed flat.

According to the embodiment of the disclosure, in the unfolded state of the foldable electronic device 1, the hinge portion 14 may support the third display area 153 of the first display module 15 so that the third display area 153 is substantially flat. For example, in the unfolded state of the foldable electronic device 1, the hinge portion 14 supports the third display area 153 so that the third display area 153 may be disposed flat with no or reduced sagging. Therefore, it is possible to reduce creases.

According to the embodiment of the disclosure, in case that an external force (e.g., external pressure such as a touch input made by a user's finger or a touch input made by an electronic pen) is applied to the third display area 153 in the unfolded state of the foldable electronic device 1, the hinge portion 14 may support the third display area 153 to reduce a sag of the third display area 153 and allow the third display area 153 to be maintained to be flat.

According to the embodiment of the disclosure, in case that an external impact is applied because of a fall of the foldable electronic device 1 or the like in the unfolded state of the foldable electronic device 1, the hinge portion 14 may be configured to reduce or absorb the external impact to reduce the influence of the external impact applied to the third display area 153.

According to the embodiment of the disclosure, the foldable electronic device 1 may be implemented in an in-folding manner so that the display area 150 of the first display module 15 (or the front surface of the foldable electronic device 1 through which the display area 150 is visually recognized) may be folded inward. FIG. 2 illustrates a fully folded state of the foldable electronic device 1 in which the first housing 11 and the second housing 12 are disposed so as not to become closer to each other any further. In the fully folded state of the foldable electronic device 1, the first display area 151 and the second display area 152 (or the first front surface area and the second front surface area) may face each other. For example, in the fully folded state of the foldable electronic device 1, an angle between the first housing 11 and the second housing 12 (or an angle between the first display area 151 and the second display area 152 or an angle between the first front surface area and the second front surface area) may be about 0 to about 10 degrees. In the fully folded state of the foldable electronic device 1, the display area 150 may be substantially invisible.

Although not illustrated separately, the foldable electronic device 1 may be disposed in an intermediate state between the unfolded state and the fully folded state. For example, in the intermediate state of the foldable electronic device 1 in which the angle between the first housing 11 and the second housing 12 is equal to or higher than a predetermined angle, the foldable electronic device 1 may be configured to provide a use environment in which the user may use the display area 150.

Hereinafter, 'the folded state of the foldable electronic device 1' of the disclosure may refer to the fully folded state compared to the intermediate state.

According to the embodiment of the disclosure, the display area 150 of the first display module 15 may substantially provide (or define) the front surface of the external appearance of the foldable electronic device 1. The front surface of the foldable electronic device 1 may include a first front surface area provided (or defined) by the first display area 151, a second front surface area provided (or defined) by the second display area 152, and a third front surface area provided (or defined) by the third display area 153. For example, the illustrated coordinate axes of the foldable electronic device 1 are illustrated based on the first housing 11, and an +z-axis direction may be defined or interpreted as a direction substantially directed toward the flat first front surface area. For example, the first front surface area provided (or defined) by the first display area 151 may be substantially parallel to an x-y plane. In the unfolded state of the foldable electronic device 1, the front surface of the foldable electronic device 1 may be provided (or formed) as a substantially flat surface.

According to the embodiment of the disclosure, in the unfolded state of the foldable electronic device 1, the display area 150 of the first display module 15 may be provided (or formed) to be symmetric with respect to a centerline A of the foldable electronic device 1. In the unfolded state of the foldable electronic device 1, the centerline A of the foldable electronic device 1 may correspond to a middle portion of a width of the third display area 153 extending from a first boundary between the first display area 151 and the third display area 153 to a second boundary between the second display area 152 and the third display area 153. For example, the illustrated +x coordinate axis may be substantially perpendicular to the centerline A, and the illustrated +y coordinate axis may be substantially parallel to the centerline A.

According to various embodiments of the disclosure, the centerline A of the foldable electronic device 1 may be defined or interpreted as a 'folding axis' of the foldable housing 10 or the foldable electronic device 1. The folding axis may be provided (or defined) substantially by the hinge portion 14.

According to the embodiment of the disclosure, in the folded state of the foldable electronic device 1, the third display area 153 disposed in the bent shape may be provided (or formed) to be substantially symmetric with respect to the centerline A of the foldable electronic device 1.

According to the embodiment of the disclosure, in the unfolded state of the foldable electronic device 1, the display area 150 of the first display module 15 may have a substantially rectangular shape.

According to the embodiment of the disclosure, the first housing 11 may include a first frame (also referred to as a first frame structure or a first framework) 111, and a first cover 112 disposed on (or coupled to) the first frame 111. A combination of the first frame 111 and the first cover 112 may provide (or define) a 'first rear surface area' and a 'first side surface area' of the external appearance of the foldable electronic device 1. The first frame 111 may provide (or define) at least a part of the first side surface area of the foldable electronic device 1. The first cover 112 may provide (or define) at least a part of the first rear surface area of the foldable electronic device 1. The first rear surface area may be directed in a direction opposite to a direction of the first front surface area of the foldable electronic device 1 provided (or defined) by the first display area 151 of the first display module 15.

According to the embodiment of the disclosure, the first frame 111 may include a first side (also referred to as a first lateral portion, a first lateral member, a first lateral structure, or a first side surface bezel structure) 1112. The first side 1112 may surround at least a part of a space between the first display area 151 and the first cover 112 and provide (or define) at least a part of the first side surface area of the external appearance of the foldable electronic device 1.

According to the embodiment of the disclosure, the first frame 111 may include a first support plate 1111 extending from the first side 1112 or connected to the first side 1112. The first support plate 1111 may be a structural element positioned in the foldable electronic device 1 while corresponding to the first housing 11.

According to the embodiment of the disclosure, the first frame 111 may be provided (or defined) as an integrated or single structure (e.g., a single continuous structure or a complete structure) including the first support plate 1111 and the first side 1112.

According to the embodiment of the disclosure, the first frame 111 may be provided as a combination of a conductor (or metal body) (not illustrated separately) including one or more conductive parts and a non-conductor (or nonmetallic body) (not illustrated separately) including one or more non-conductive parts.

According to the embodiment of the disclosure, the first support plate 1111 may be at least partially positioned between the first display area 151 and the first cover 112. The first display area 151 may be disposed on the first support plate 1111, and the first support plate 1111 may support the first display area 151.

According to the embodiment of the disclosure, various electrical constituent elements (not illustrated separately), such as a first printed circuit board or a first battery, may be at least partially disposed between the first frame 111 and the first cover 112 and disposed on the first support plate 1111 of the first frame 111.

According to the embodiment, electrical constituent elements (or electronic components) or various members related to the electrical constituent elements may be disposed on the first frame 111 or the first support plate 1111 or supported by the first frame 111 or the first support plate 1111. For example, the first support plate 1111 may include a first support area (also referred to as a first support surface) 1111A and a third support area (also referred to as a third support surface) 1111B. The first support area 1111A may be directed substantially toward the first display area 151 of the first display module 15. The third support area 1111B may be positioned opposite to the first support area 1111A. The third support area 1111B may be directed substantially toward the first cover 112. Electrical constituent elements (or electronic components) or various members related to the electrical constituent elements may be disposed in the first support area 1111A and/or the third support area 1111B or supported by the first support area 1111A and/or the third support area 1111B.

According to the embodiment of the disclosure, the second housing 12 may include a second frame (also referred to as a second frame structure or a second framework) 121, and/or a second cover 122 disposed on the second frame 121. A combination of the second frame 121 and the second cover 122 may provide (or define) a second rear surface area and a second side surface area of the external appearance of the foldable electronic device 1. The second frame 121 may provide (or define) at least a part of the second side surface area of the foldable electronic device 1. The second cover 122 may provide (or define) at least a part of the second rear surface area of the foldable electronic device 1. The second rear surface area may be directed in a direction opposite to a direction of the second front surface area of the foldable electronic device 1 provided (or defined) by the second display area 152.

According to the embodiment of the disclosure, the second frame 121 may include a second side (also referred to as a second lateral portion, a second lateral member, a second lateral structure, or a second lateral bezel structure) 1212. The second side 1212 may surround at least a part of a space between the second display area 152 and the second cover 122 and provide (or define) at least a part of the second side surface area of the external appearance of the foldable electronic device 1.

According to the embodiment of the disclosure, the second frame 121 may include a second support plate 1211 extending from the second side 1212 or connected to the second side 1212. The second support plate 1211 may be a structural element positioned in the foldable electronic device 1 while corresponding to the second housing 12.

According to the embodiment of the disclosure, the second frame 121 may be provided as an integrated or single structure (e.g., a single continuous structure or a complete structure) including the second support plate 1211 and the second side 1212.

According to the embodiment of the disclosure, the second frame 121 may be provided as a combination of a conductor (or metal body) (not illustrated separately) including one or more conductive parts and a non-conductor (or nonmetallic body) (not illustrated separately) including one or more non-conductive parts.

According to the embodiment of the disclosure, the second support plate 1211 may be at least partially positioned between the second display area 152 and the second cover 122. The second display area 152 may be disposed on the second support plate 1211, and the second support plate 1211 may support the second display area 152.

According to the embodiment of the disclosure, various electrical constituent elements (not illustrated separately), such as a second printed circuit board or a second battery, may be at least partially disposed between the second frame 121 and the second cover 122 and disposed on the second support plate 1211 of the second frame 121.

According to the embodiment of the disclosure, electrical constituent elements (or electronic components) or various members related to the electrical constituent elements may be may be disposed on the second frame 121 or the second support plate 1211 or supported by the second frame 121 or the second support plate 1211. For example, the second support plate 1211 may include a second support area (also referred to as a second support surface) 1211A and a fourth support area (also referred to as a fourth support surface) 1211B. The second support area 1211A may be directed substantially toward the second display area 152 of the first display module 15. The fourth support area 1211B may be positioned opposite to the second support area 1211A. The fourth support area 1211B may be directed substantially toward the second cover 122. Electrical constituent elements (or electronic components) or various members related to the electrical constituent elements may be disposed on the second support area 1211A and/or the fourth support area 1211B or supported by the second support area 1211A and/or the fourth support area 1211B.

According to the embodiment of the disclosure, the first side 1112 of the first frame 111 may include a first rim B1, a second rim B2, a third rim B3, and/or a fourth rim B4. The first rim B1 may extend in a direction perpendicular to the centerline A of the foldable electronic device 1. The third rim B3 may be spaced apart from the first rim B1 in the direction of the centerline A of the foldable electronic device 1, and the third rim B3 may be substantially parallel to the first rim B1. The second rim B2 may extend or connect one end of the first rim B1 and one end of the third rim B3. The fourth rim B4 may extend or connect the other end of the first rim B1 and the other end of the third rim B3. The second rim B2 and the fourth rim B4 may be substantially parallel to each other. The fourth rim B4 may be positioned to be closer to the centerline A of the foldable electronic device 1 than the second rim B2 to the centerline A of the foldable electronic device 1.

According to the embodiment of the disclosure, a first corner C1, at which the first rim B1 and the second rim B2 are extended or connected, and/or a second corner C2, at which the second rim B2 and the third rim B3 are extended or connected, may be provided (or formed) in a smoothly curved shape.

According to the embodiment of the disclosure, when viewed from above the first cover 112, the first rim B1, the second rim B2, the third rim B3, and the fourth rim B4 may surround the first cover 112.

According to the embodiment of the disclosure, the second side 1212 of the second frame 121 may include a fifth rim B5, a sixth rim B6, a seventh rim B7, and/or an eighth rim B8. The fifth rim B5 may extend in a direction perpendicular to the centerline A of the foldable electronic device 1. The seventh rim B7 may be spaced apart from the fifth rim B5 in the direction of the centerline A of the foldable electronic device 1, and the seventh rim B7 may be substantially parallel to the fifth rim B5. The sixth rim B6 may extend or connect one end of the fifth rim B5 and one end of the seventh rim B7. The eighth rim B8 may extend or connect the other end of the fifth rim B5 and the other end of the seventh rim B7. The sixth rim B6 and the eighth rim B8 may be substantially parallel to each other. The eighth rim B8 may be positioned to be closer to the centerline A of the foldable electronic device 1 than the sixth rim B6 to the centerline A of the foldable electronic device 1.

According to the embodiment of the disclosure, a third corner C3, at which the fifth rim B5 and the sixth rim B6 are extended or connected, and/or a fourth corner C4, at which the sixth rim B6 and the seventh rim B7 are extended or connected, may be provided (or formed) in a smoothly curved shape.

According to the embodiment of the disclosure, when viewed from above the second cover 122, the fifth rim B5, the sixth rim B6, the seventh rim B7, and the eighth rim B8 may surround the second cover 122.

According to the embodiment of the disclosure, in the folded state of the foldable electronic device 1, the first side 1112 of the first frame 111 and the second side 1212 of the second frame 121 may be aligned and overlap each other. In the folded state of the foldable electronic device 1, the first rim B1 and the fifth rim B5 may be aligned and overlap each other. In the folded state of the foldable electronic device 1, the second rim B2 and the sixth rim B6 may be aligned and overlap each other. In the folded state of the foldable electronic device 1, the third rim B3 and the seventh rim B7 may be aligned and overlap each other.

According to the embodiment of the disclosure, the first rim B1, the second rim B2, and the third rim B3 may define one side bezel (or screen bezel) that surrounds one side area of the first display module 15 based on the centerline A of the foldable electronic device 1. The fifth rim B5, the sixth rim B6, and the seventh rim B7 may define the other side bezel (or screen bezel) that surrounds the other side area of the first display module 15 based on the centerline A of the foldable electronic device 1.

According to the embodiment of the disclosure, the fourth rim B4 and the eighth rim B8 may be positioned opposite to the third display area 153. When viewed from above the front surface of the foldable electronic device 1 in the unfolded state, the fourth rim B4 and the eighth rim B8 may be invisible.

According to the embodiment of the disclosure, the hinge housing (also referred to as a hinge cover) 13 may be connected to one or more hinge modules (e.g., the first hinge module 141, the second hinge module 142, and the third hinge module 143) included in the hinge portion 14.

According to the embodiment of the disclosure, when the foldable electronic device 1 is changed from the unfolded state to the folded state, the relative position between the first frame 111 and the second frame 121 connected by the hinge portion 14 is changed, and the state of the hinge portion 14 coupled to the hinge housing 13 is changed, such that a gap between the first frame 111 and the second frame 121 may be opened at a side opposite to the third display area 153. The hinge housing 13 may be exposed to the outside through the opened gap. For example, in the folded state of the foldable electronic device 1, the hinge housing 13 may be exposed to the outside through the opened gap between the fourth rim B4 of the first frame 111 and the eighth rim B8 of the second frame 121. A width of the gap between the fourth rim B4 of the first frame 111 and the eighth rim B8 of the second frame 121 may vary depending on an angle between the first frame 111 and the second frame 121. The hinge housing 13 may be exposed to a larger degree in the folded state of the foldable electronic device 1 than in the intermediate state of the foldable electronic device 1. In the folded state of the foldable electronic device 1, the hinge housing 13 may be a part of the external appearance that covers the interior of the foldable electronic device 1. In the folded state of the foldable electronic device 1, the side surface of the foldable electronic device 1 may include the first side surface area provided by the first side 1112 of the first frame 111, the second side surface area provided by the second side 1212 of the second frame 121, and a third side surface area provided by the hinge housing 13.

According to the embodiment of the disclosure, when the foldable electronic device 1 is changed from the folded state to the unfolded state, the relative position between the first frame 111 and the second frame 121 connected by the hinge portion 14 is changed, and the state of the hinge portion 14 coupled to the hinge housing 13 is changed, such that the gap between the first frame 111 and the second frame 121 may be closed at the side opposite to the third display area 153. For example, in the unfolded state of the foldable electronic device 1, the gap between the fourth rim B4 of the first frame 111 and the eighth rim B8 of the second frame 121 may be closed, and the hinge housing 13 may not be exposed to the outside.

According to the embodiment of the disclosure, the second display module 16 (also referred to as a second display) may be positioned between the second cover 122 and the second support plate 1211 of the second frame 121. The second display module 16 may be disposed on or coupled to the second cover 122 and/or the second support plate 1211. The display area of the second display module 16 may be visually visible through the second cover 122.

According to the embodiment of the disclosure, the foldable electronic device 1 may be substituted for the first display module 15 and configured to display an image through the second display module 16 in the folded state.

According to the embodiment of the disclosure, the first camera module 201, the second camera module 202, the third camera module 203, the fourth camera module 204, and/or the fifth camera module 205 may include one or more lenses, one or more image sensors, and/or one or more image signal processors (image signal processors (ISPs)).

According to the embodiment of the disclosure, the first camera module 201, the second camera module 202, and the third camera module 203 may be accommodated in the first housing 11 while corresponding to the first cover 112 (or the first rear surface area of the foldable electronic device 1). For example, the first cover 112 may include a first camera hole (or first light transmission area) corresponding to the first camera module 201, a second camera hole (or second light transmission area) corresponding to the second camera module 202, and/or a third camera hole (or third light transmission area) corresponding to the third camera module 203. The position of the camera module or the number of camera modules, which are accommodated in the first housing 11 while corresponding to the first cover 112, may be variously implemented without being limited to the illustrated example.

According to the embodiment of the disclosure, the first camera module 201 (also referred to as a first camera, a first rear surface camera module, or a first rear surface camera), the second camera module 202 (also referred to as a second camera, a second rear surface camera module, or a second rear surface camera), or the third camera module 203 (also referred to as a third camera, a third rear surface camera module, or a third rear surface camera) may include a wide-angle camera module, a telephoto camera module, a color camera module, a monochrome camera module, or an IR camera module (e.g., a time-of-flight (TOF) camera module or a structured light camera module).

According to the embodiment of the disclosure, the first camera module 201, the second camera module 202, and the third camera module 203 may have different attributes (e.g., view angles) or functions.

According to various embodiments of the disclosure, the first camera module 201, the second camera module 202, or the third camera module 203 may provide different view angles (or lenses with different view angles). The foldable electronic device 1 may selectively use the view angle of the first camera module 201, the second camera module 202, or the third camera module 203 based on the user's selection related to the view angles.

According to the embodiment of the disclosure, the fourth camera module 204 may be accommodated in the first housing 11 while corresponding to the first front surface area of the foldable electronic device 1.

According to the embodiment of the disclosure, the fourth camera module 204 (also referred to as a fourth camera, a first front surface camera module, or a first front surface camera) may overlap the first display area 151 of the first display module 15 when viewed from above the first front surface area of the foldable electronic device 1. The fourth camera module 204 may be positioned on a rear surface of the first display area 151 or positioned below the first display area 151. The position of the fourth camera module 204 or the fourth camera module 204 may not be substantially visually distinguished (or exposed) when viewed from the outside of the foldable electronic device 1. For example, the fourth camera module 204 may include a hidden display rear surface camera (e.g., an under-display camera (UDC)). External light may reach the fourth camera module 204 through the first display module 15.

According to various embodiments of the disclosure, although not illustrated separately, the fourth camera module 204 may be accommodated in the second housing 12 while corresponding to the second front surface area of the foldable electronic device 1.

According to various embodiments of the disclosure, although not illustrated separately, an additional camera module (not illustrated separately) may be accommodated in the second housing 12 while corresponding to the second front surface area of the foldable electronic device 1.

According to the embodiment of the disclosure, the fifth camera module 205 may be accommodated in the second housing 12 while corresponding to the second cover 122 (or the second rear surface area of the foldable electronic device 1).

According to the embodiment of the disclosure, the fifth camera module 205 may be aligned and positioned in an opening provided in the second display module 16, or the fifth camera module 205 may be at least partially inserted into the opening. External light may reach the fifth camera module 205 through the opening provided in the second cover 122 and the second display module 16. The opening of the second display module 16, which is aligned with or overlaps the fifth camera module 205, may be a through-hole. In various embodiments, the opening of the second display module 16, which is aligned with or overlaps the fifth camera module 205, may be provided in the form of a notch (not illustrated separately).

According to various embodiments of the disclosure, the fifth camera module 205 (also referred to as a fifth camera, a second front surface camera module, or a second front surface camera) may overlap the second display module 16 when viewed from above the second rear surface area of the foldable electronic device 1. The fifth camera module 205 may be positioned on a rear surface of the second display module 16 or positioned below the second display module 16. The position of the fifth camera module 205 or the fifth camera module 205 may not be substantially visually distinguished (or exposed) when viewed from the outside of the foldable electronic device 1. For example, the fifth camera module 205 may include a hidden under-display camera (e.g., a UDC). External light may reach the fifth camera module 205 through the second cover 122 and the second display module 16.

According to various embodiments of the disclosure, the first camera module 201, the second camera module 202, the third camera module 203, the fourth camera module 204, or the fifth camera module 205 may operate as at least a part of the sensor module. For example, the IR camera module may operate as at least a part of the sensor module.

According to the embodiment of the disclosure, the light-emitting module 206 may be accommodated in the first housing 11 while corresponding to the first cover 112 (or the first rear surface area of the foldable electronic device 1). The first cover 112 may include a flash hole (or a fourth light transmission area) corresponding to the light-emitting module 206. For example, the light-emitting module 206 may include an LED or a xenon lamp. The light-emitting module 206 may include a light source for the first camera module 201, the second camera module 202, and/or the third camera module 203.

According to various embodiments of the disclosure, the foldable electronic device 1 may further include another light-emitting module (not illustrated separately) accommodated in the foldable housing 10 while corresponding to the front surface of the foldable electronic device 1. The light emitting module may provide status information on the foldable electronic device 1 in the form of light. In various embodiments, the light-emitting module may provide a light source that operates in conjunction with an operation of the fourth camera module 204.

According to the embodiment of the disclosure, the first sensor module 207 may be accommodated in the foldable housing 10 while corresponding to the front surface of the foldable electronic device 1.

According to the embodiment of the disclosure, the first sensor module 207 may include an optical sensor module. For example, the optical sensor module may include a proximity sensor module or an illuminance sensor module.

According to the embodiment of the disclosure, the first sensor module 207 may overlap the first display area 151 of the first display module 15 when viewed from above the first front surface area of the foldable electronic device 1. The first sensor module 207 may be positioned on the rear surface of the first display area 151 or positioned below the first display area 151. The position of the first sensor module 207 or the first sensor module 207 may not be substantially visually distinguished (or exposed) when viewed from the outside of the foldable electronic device 1. External light may reach the first sensor module 207 through the first display module 15.

According to the embodiment of the disclosure, the second sensor module 208 may be accommodated in the foldable housing 10 while corresponding to the second cover 122 (or the second rear surface area of the foldable electronic device 1).

According to the embodiment of the disclosure, the second sensor module 208 may include an optical sensor module. For example, the optical sensor module may include a proximity sensor module or an illuminance sensor module.

According to the embodiment of the disclosure, the second sensor module 208 may overlap the display area of the second display module 16 when viewed from above the second rear surface area of the foldable electronic device 1. The second sensor module 208 may be positioned on the rear surface of the display area of the second display module 16 or positioned below the display area of the second display module 16. The position of the second sensor module 208 or the second sensor module 208 may not be substantially visually distinguished (or exposed) when viewed from the outside of the foldable electronic device 1. External light may reach the second sensor module 208 through the second cover 122 and the display area of the second display module 16.

According to various embodiments of the disclosure, the foldable electronic device 1 may further include various sensor modules (e.g., biosensor modules) (not illustrated separately).

According to the embodiment of the disclosure, the first sound input module may include a first microphone (also referred to as a first microphone) (not illustrated separately). The second sound input module may include a second microphone (also referred to as a second microphone) (not illustrated separately). The third sound input module may include a third microphone (also referred to as a third microphone) (not illustrated separately). The fourth sound input module may include a fourth microphone (also referred to as a fourth microphone) (not illustrated separately). For example, the first microphone may be accommodated in the first housing 11 while corresponding to a first microphone hole H11 included in the first rim B1 of the first side 1112. For example, the second microphone may be accommodated in the first housing 11 while corresponding to a second microphone hole H12 included in the third rim B3 of the first side 1112. For example, the third microphone may be accommodated in the first housing 11 while corresponding to a third microphone hole H13 included in the third rim B3 of the first side 1112. For example, the fourth microphone may be accommodated in the second housing 12 while corresponding to a fourth microphone hole H14 included in the seventh rim B7 of the second side 1212. The position of the microphone, the number of microphones, the position of the microphone hole corresponding to the microphone, or the number of microphone holes may be variously implemented without being limited to the illustrated example.

According to the embodiment of the disclosure, the first sound output module may include a first speaker (not illustrated separately). The second sound output module may include a second speaker (not illustrated separately). The first speaker or the second speaker may be a speaker for multimedia playback or recording playback. For example, the first speaker may be accommodated in the second housing 12 while corresponding to a first speaker hole H21 included in the second side 1212. For example, the second speaker may be accommodated in the second housing 12 while corresponding to a second speaker hole H21 provided in the second side 1212. The position of the speaker for multimedia playback or recording playback, the number of speakers, the position of the speaker hole corresponding to the speaker, or the number of speaker holes may be variously implemented without being limited to the illustrated example.

According to the embodiment of the disclosure, the third sound output module may include a third speaker (not illustrated separately). The third speaker may include a telephone receiver. For example, the third speaker may be accommodated in the second housing 12 while corresponding to a third speaker hole H23 provided between the second cover 122 and the seventh rim B7 of the second side 1212. The position of the telephone speaker, the number of speakers, the position of the speaker hole corresponding to the speaker, or the number of speaker holes may be variously implemented without being limited to the illustrated example.

According to the embodiment of the disclosure, the key input module may include a first key (also referred to as a first side key) 209, a second key (also referred to as a second side key) 210, and/or a key signal generation part (not illustrated separately). For example, the first key 209 may be positioned in a first keyhole included in the second rim B2 of the first side 1112, and the second key 210 may be positioned in a second keyhole included in the second rim B2 of the first side 1112. The key signal generation part may generate a first key signal on the basis that the first key 209 is pushed or touched, and the key signal generation part may generate a second key signal on the basis that the second key 210 is pushed or touched. The position of the key input module or the number of key input modules may be variously implemented without being limited to the illustrated example.

According to the embodiment of the disclosure, the first connection terminal 211 (also referred to as a first connector or a first interface terminal) may be accommodated in the first housing 11 while corresponding to a first connection terminal hole (e.g., a first connector hole) included in the first rim B1 of the first side 1112. The foldable electronic device 1 may transmit and/or receive electric power and/or data to and/or from an external electronic device electrically connected to the first connection terminal 211. For example, the first connection terminal 211 may include a USB connector or an HDMI connector. The position of the first connection terminal hole corresponding to the first connection terminal 211 and the first connection terminal 211 may be variously implemented without being limited to the illustrated example.

According to the embodiment of the disclosure, the second connection terminal (referred to as a second connector or a second interface terminal) 212 may be accommodated in the second housing 12 while corresponding to a second connection terminal hole (e.g., a second connector hole) included in the sixth rim B6 of the second side 1212. An external storage medium, such as a secure digital (SD) memory card, a SIM card, or a universal SIM (USIM), may be connected to the second connection terminal 212. The position of the second connection terminal hole corresponding to the second connection terminal 212 and the second connection terminal 212 may be variously implemented without being limited to the illustrated example.

The foldable electronic device 1 may further include various constituent elements in accordance with the provided form. All the constituent elements cannot be enumerated because the constituent element is variously deformed in accordance with the tendency of convergence of the foldable electronic device 1. However, the foldable electronic device 1 may further additionally include a constituent element equal in level to the above-mentioned constituent elements. In various embodiments, particular components may be excluded from the components or substituted with other components in accordance with the provided form.

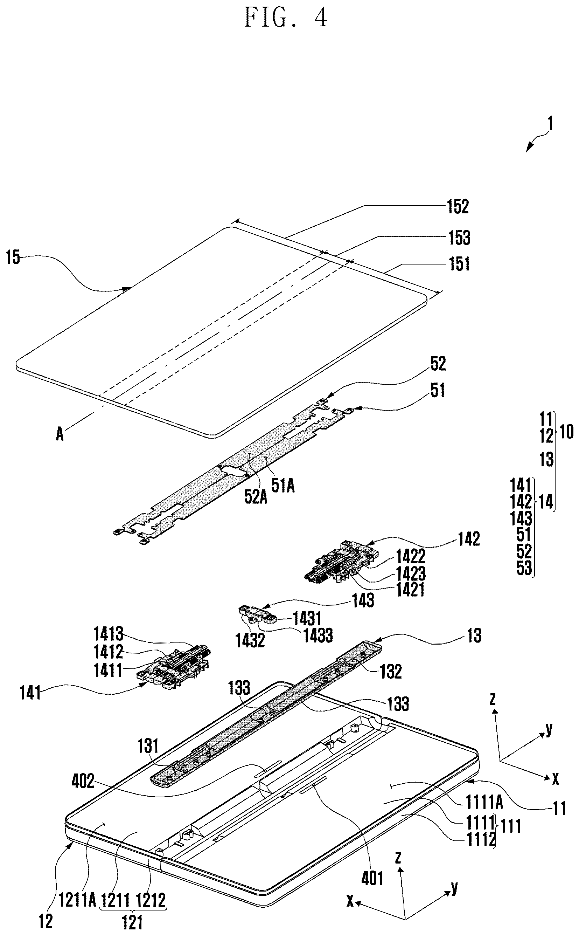

FIG. 4 is an exploded perspective view of a part of a foldable electronic device in the unfolded state according to an embodiment of the disclosure.

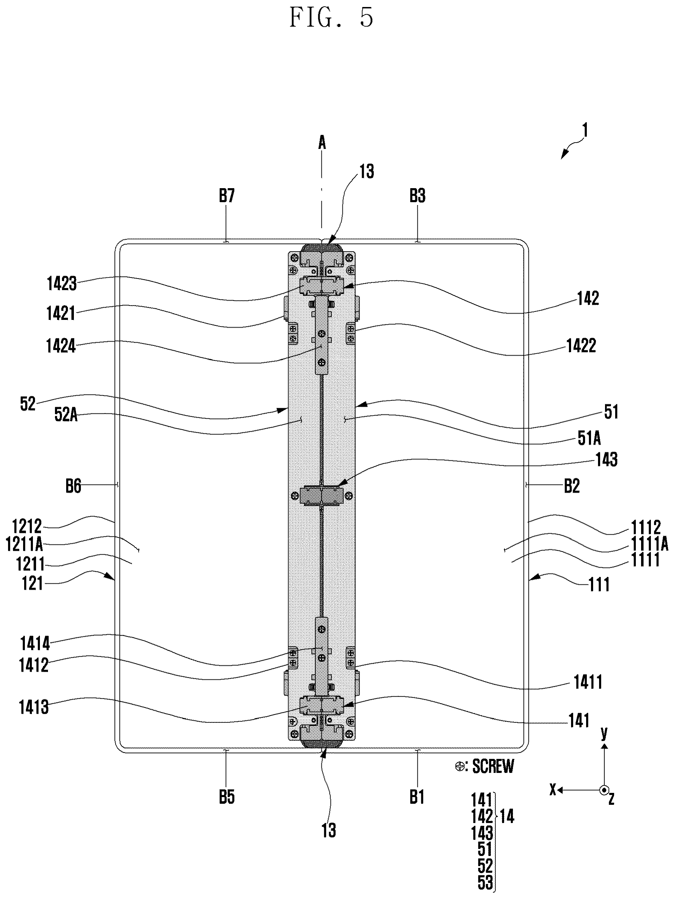

FIG. 5 is a view illustrating a part of a foldable electronic device in the unfolded state according to an embodiment of the disclosure.

Referring FIGS. 4 and 5, the foldable electronic device 1 may include the foldable housing 10 and the first display module 15. A description of some constituent elements denoted by the same reference numerals as the constituent elements illustrated in FIGS. 1, 2, and 3 will be omitted.

According to the embodiment of the disclosure, the foldable housing 10 may include the first housing 11, the second housing 12, the hinge housing 13, and/or the hinge portion 14.

According to the embodiment of the disclosure, the first housing 11 may include the first frame 111. The first frame 111 may include the first support plate 1111 and the first side 1112.

According to the embodiment of the disclosure, the first support area 1111A of the first support plate 1111 may provide a first front surface seating portion for stably disposing or supporting one or more constituent elements such as the first display area 151 of the first display module 15. For example, the first front surface seating portion may be provided as a combination of surface areas having different heights.

According to the embodiment of the disclosure, the third support area 1111B (see FIG. 3) of the first support plate 1111 may provide a first rear surface seating portion for stably disposing or supporting one or more constituent elements such as the first printed circuit board (not illustrated separately) and/or the first battery (not illustrated separately). For example, the first rear surface seating portion may be provided as a combination of surface areas having different heights.

According to the embodiment of the disclosure, the second housing 12 may include the second frame 121. The second frame 121 may include the second support plate 1211 and the second side 1212.

According to the embodiment of the disclosure, the second support area 1211A of the second support plate 1211 may provide a second front surface seating portion for stably disposing or supporting one or more constituent elements such as the second display area 152 of the first display module 15. For example, the second front surface seating portion may be provided as a combination of surface areas having different heights.

According to the embodiment of the disclosure, the fourth support area 1211B (see FIG. 3) of the second support plate 1211 may provide a second rear surface seating portion for stably disposing or supporting one or more constituent elements such as the second printed circuit board (not illustrated separately) and/or the second battery (not illustrated separately). For example, the second rear surface seating portion may be provided as a combination of surface areas having different heights.

According to the embodiment of the disclosure, the first display area 151 of the first display module 15 may be disposed in the first support area 1111A of the first support plate 1111, and the second display area 152 may be disposed in the second support area 1211A of the second support plate 1211 by means of an adhesive material (or a bonding material). For example, the adhesive material may include a thermally reactive adhesive material (or a thermally reactive bonding material), a photoreactive adhesive material (or a photoreactive bonding material), a general adhesive agent (or a general bonding agent), and/or a double-sided tape.

According to the embodiment of the disclosure, the hinge housing 13 may be coupled to the hinge portion 14. For example, the hinge housing 13 may be connected to the first frame 111 of the first housing 11 and the second frame 121 of the second housing 12 by means of the hinge portion 14. When the foldable electronic device 1 is changed between the unfolded state and the folded state, the first housing 11 and the second housing 12, which are connected by the hinge portion 14, may rotate in different directions based on the hinge portion 14 when viewed in the direction of the centerline A of the foldable electronic device 1. In the unfolded state of the foldable electronic device 1, the hinge housing 13 may be covered by the first frame 111 of the first housing 11 and the second frame 121 of the second housing 12. In the folded state of the foldable electronic device 1, the hinge housing 13 may be exposed to the outside through a portion between the first frame 111 of the first housing 11 and the second frame 121 of the second housing 12.

According to the embodiment of the disclosure, the hinge housing 13 may include a seating portion configured to stably display and support the first hinge module 141, the second hinge module 142, and the third hinge module 143. The seating portion may be provided as a combination of surface areas having different heights. For example, the seating portion may include a sixth recess 131 corresponding to the first hinge module 141 corresponding to the first hinge module 141, a seventh recess 132 corresponding to the second hinge module 142, and/or an eighth recess 133 corresponding to the third hinge module 143.

According to the embodiment of the disclosure, the hinge housing 13 may be defined or interpreted as a constituent element included in the hinge portion 14.

According to the embodiment of the disclosure, the hinge portion 14 may include the first hinge module (also referred to as a first hinge assembly) 141, the second hinge module (also referred to as a second hinge assembly) 142, the third hinge module (also referred to as a third hinge assembly) 143, a first plate (also referred to as a first wing plate) 51, and/or a second plate (also referred to as a second wing plate) 52.

According to the embodiment of the disclosure, the first hinge module 141, the second hinge module 142, and the third hinge module 143 may connect the first frame 111 and the second frame 121. The first frame 111 and the second frame 121 may be rotatably connected to each other by means of the first hinge module 141, the second hinge module 142, and the third hinge module 143.

According to the embodiment of the disclosure, the first hinge module 141, the second hinge module 142, and the third hinge module 143 may be disposed along the centerline A of the foldable electronic device 1, and the third hinge module 143 may be positioned between the first hinge module 141 and the second hinge module 142.

According to the embodiment of the disclosure, the third hinge module 143 may be disposed to correspond to a center between the first hinge module 141 and the second hinge module 142 (e.g., a point on the centerline A disposed at substantially the same distance from the first hinge module 141 and the second hinge module 142).

According to the embodiment of the disclosure, the first hinge module 141 may include a first bracket 1411, a second bracket 1412, and/or a first bracket connection part 1413. For example, the first bracket 1411 may be disposed in or coupled to the first support area 1111A of the first frame 111 by screw-fastening. For example, the second bracket 1412 may be disposed in or coupled to the second support area 1211A of the second frame 121 by screw-fastening. The first bracket connection part 1413 may connect the first bracket 1411 and the second bracket 1412. The first bracket 1411 and the second bracket 1412 may rotate relative to the first bracket connection part 1413.

According to the embodiment of the disclosure, the first bracket connection part 1413 of the first hinge module 141 may be configured such that the first frame 111, to which the first bracket 1411 of the first hinge module 141 is fixed, and the second frame 121, to which the second bracket 1412 of the first hinge module 141 is fixed, may rotate at substantially the same angle in opposite directions.

According to the embodiment of the disclosure, the first bracket connection part 1413 of the first hinge module 141 may be configured such that the first frame 111, to which the first bracket 1411 of the first hinge module 141 is fixed, and the second frame 121, to which the second bracket 1412 of the first hinge module 141 is fixed, may be rotated by at least one predetermined angle and maintained. For example, the first bracket connection part 1413 may have a free-stop function.

According to the embodiment of the disclosure, the first bracket connection part 1413 of the first hinge module 141 may be configured to provide a force that enables the first frame 111, to which the first bracket 1411 of the first hinge module 141 is fixed, and the second frame 121, to which the second bracket 1412 of the first hinge module 141 is fixed, to rotate relative to each other. For example, although not illustrated separately, the first bracket connection part 1413 may include a combination of at least one shaft, at least one cam gear, and/or at least one compression spring configured to provide elasticity.

According to the embodiment of the disclosure, the first bracket connection part 1413 of the first hinge module 141 may be coupled to the hinge housing 13. For example, the first bracket connection part 1413 may be coupled to the hinge housing 13 by screw-fastening.

According to the embodiment of the disclosure, the first bracket connection part 1413 of the first hinge module 141 may be disposed in or coupled to the sixth recess 131, which is provided (or defined) in the hinge housing 13, by screw-fastening.

According to the embodiment of the disclosure, the second hinge module 142 may be provided to be at least partially or substantially identical to the first hinge module 141. For example, the second hinge module 142 may include a third bracket 1421 (e.g., the first bracket 1411), a fourth bracket 1422 (e.g., the second bracket 1412), and/or a second bracket connection part 1423 (e.g., the first bracket connection part 1413). In the embodiment, the second hinge module 142 may be disposed in the foldable electronic device 1 in a direction opposite to the direction in which the first hinge module 141 is disposed. The third bracket 1421 of the second hinge module 142 may be disposed in or coupled to the second support area 1211A of the second frame 121, and the fourth bracket 1422 of the second hinge module 142 may be disposed in or coupled to the first support area 1111A of the first frame 111.

According to the embodiment of the disclosure, the second bracket connection part 1423 of the second hinge module 142 may be coupled to the hinge housing 13. For example, the second bracket connection part 1423 may be coupled to the hinge housing 13 by screw-fastening.

According to the embodiment of the disclosure, the second bracket connection part 1423 of the second hinge module 142 may be disposed in or coupled to the seventh recess 132, which is provided (or defined) in the hinge housing 13, by screw-fastening.

According to the embodiment of the disclosure, the third hinge module 143 may include a guide rail assembly or a rotational motion guide. For example, the third hinge module 143 may include a first slider 1431, a second slider 1432, and a guide rail 1433. The first slider 1431 may be connected to the guide rail 1433 so as to be slidable relative to the guide rail 1433. The second slider 1432 may be connected to the guide rail 1433 so as to be slidable relative to the guide rail 1433. The guide rail 1433 may include a first guide rail in a sliding pair relationship with the first slider 1431, and a second guide rail in a sliding pair relationship with the second slider 1432.

According to the embodiment of the disclosure, the guide rail 1433 of the third hinge module 143 may be coupled to the hinge housing 13. For example, the guide rail 1433 may be coupled to the hinge housing 13 by screw-fastening.

According to the embodiment of the disclosure, the guide rail 1433 of the third hinge module 143 may be disposed in or coupled to the eighth recess 133 of the hinge housing 13 by screw-fastening.

According to various embodiments of the disclosure, although not illustrated separately, the first hinge module 141, the second hinge module 142, and/or the third hinge module 143 may be provided on various other shapes without being limited to the illustrated example.

According to the embodiment of the disclosure, the first plate 51 may be positioned to correspond to the first frame 111 of the first housing 11, and the second plate 52 may be positioned to correspond to the second frame 121 of the second housing 12. The first plate 51 and the second plate 52 may be respectively positioned at two sides based on the centerline A of the foldable electronic device 1. The first plate 51 and the second plate 52 may each have a shape in which a first width in the direction (e.g., the y-axis direction) of the centerline A of the foldable electronic device 1 is relatively larger than a second width in a direction perpendicular to the above-mentioned direction. The first plate 51 and the second plate 52 may extend from the first hinge module 141 to the second hinge module 142 across the third hinge module 143. Based on the first centerline A of the foldable electronic device 1, one side of each of the first hinge module 141, the second hinge module 142, and the third hinge module 143 may be positioned between the first plate 51 and the first support plate 1111 of the first frame 111, and the other side of each of the first hinge module 141, the second hinge module 142, and the third hinge module 143 may be positioned between the second plate 52 and the second support plate 1211 of the second frame 121.

According to the embodiment of the disclosure, the first plate 51 and the second plate 52 may be connected to the first hinge module 141, the second hinge module 142, and the third hinge module 143. For example, the first plate 51 and the second plate 52 may be coupled to the first hinge module 141, the second hinge module 142, and the third hinge module 143 by screw-fastening.

According to the embodiment of the disclosure, in the unfolded state of the foldable electronic device 1, the hinge portion 14 may be configured such that the first plate 51 and the second plate 52 support the third display area 153 of the first display module 15 so that the third display area 153 of the first display module 15 is flat.

According to the embodiment of the disclosure, the first plate 51 may include a first display support surface 51A provided to correspond to the third display area 153 of the first display module 15. The second plate 52 may include a second display support surface 52A provided to correspond to the third display area 153 of the first display module 15. In the unfolded state of the foldable electronic device 1, the first display support surface 51A and the second display support surface 52A may support the third display area 153 so that the third display area 153 is flat with respect to the first display area 151 and the second display area 152. The first display support surface 51A may include a flat surface capable of supporting one side area of the third display area 153 so that one side area of the third display area 153 is flat based on the centerline A of the foldable electronic device 1 in the unfolded state of the foldable electronic device 1. The second display support surface 52A of the second plate 52 may include a flat surface capable of supporting the other side area of the third display area 153 so that the other side area of the third display area 153 is flat based on the centerline A of the foldable electronic device 1 in the unfolded state of the foldable electronic device 1.

According to the embodiment of the disclosure, in the unfolded state of the foldable electronic device 1, the first display support surface 51A of the first plate 51 and the second display support surface 52A of the second plate 52 may substantially define an angle of about 180 degrees and be disposed without a substantial height difference. In the unfolded state of the foldable electronic device 1, the third display area 153 may be maintained to be flat by being supported by the first plate 51 and the second plate 52 even when an external force (e.g., external pressure such as a touch input made by a user's finger or a touch input made by an electronic pen) is applied to the third display area 153 of the first display module 15.

According to the embodiment of the disclosure, the first bracket connection part 1413 of the first hinge module 141 may include a first center plate 1414 aligned to correspond to the centerline A of the foldable electronic device 1. The second bracket connection part 1423 of the second hinge module 142 may include a second center plate 1424 aligned to correspond to the centerline A of the foldable electronic device 1. In the unfolded state of the foldable electronic device 1, the first center plate 1414 and the second center plate 1424 may support a partial area of the third display area 153 of the first display module 15 that corresponds to a portion between the first display support surface 51A of the first plate 51 and the second display support surface 52A of the second plate 52. In the unfolded state of the foldable electronic device 1, the first center plate 1414 and the second center plate 1424 may reduce or prevent a sag or crease of a partial area of the third display area 153 that corresponds to a gap between the first display support surface 51A of the first plate 51 and the second display support surface 52A of the second plate 52.

According to the embodiment of the disclosure, in the unfolded state of the foldable electronic device 1, the third hinge module 143 may support a partial area of the third display area 153 of the first display module 15 that corresponds to the portion between the first display support surface 51A of the first plate 51 and the second display support surface 52A of the second plate 52.

According to the embodiment of the disclosure, in the folded state of the foldable electronic device 1, the first plate 51 and the second plate 52 may be spaced apart from each other while facing each other. In the folded state of the foldable electronic device 1, the third display area 153 of the first display module 15 may be curved and positioned between the first plate 51 and the second plate 52.

According to the embodiment of the disclosure, the hinge portion 14 may be configured such that the position of the first plate 51 relative to the first frame 111 and the position of the second plate 52 relative to the second frame 121 may vary depending on the transition between the unfolded state and the folded state of the foldable electronic device 1.

According to the embodiment of the disclosure, the hinge portion 14 may be configured such that the first plate 51 and the second plate 52 define an acute angle in the unfolded state of the foldable electronic device 1. In the folded state of the foldable electronic device 1, a space between the first display support surface 51A of the first plate 51 and the second display support surface 52A of the second plate 52 may have a shape that enlarges toward the hinge housing 13 so that the third display area 153 of the first display module 15 may be disposed in a bent shape in which bending stress and/or buckling may be reduced.

According to the embodiment of the disclosure, in the folded state of the foldable electronic device 1, based on a neutral plane in the third display area 153, the third display area 153 may be disposed in a bent shape in which a collision (e.g., bending stress) between compressive stress occurring in one side area of the third display area 153 and tensile stress occurring in the other side area of the third display area 153 may be reduced.

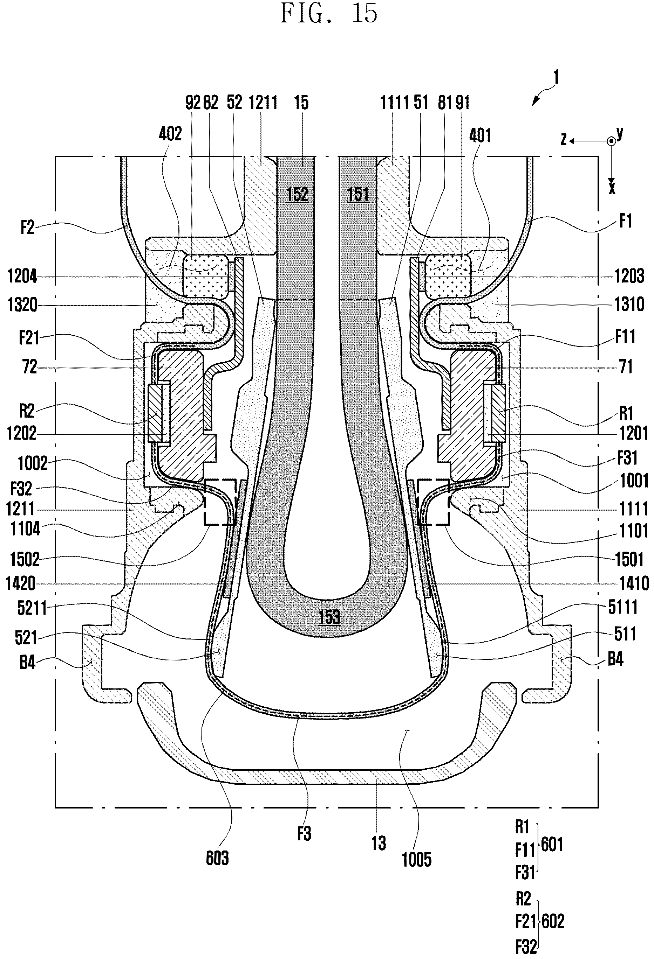

According to the embodiment of the disclosure, when the foldable electronic device 1 is changed from the unfolded state to the folded state, the third display area 153 of the first display module 15 may be positioned between the first plate 51 and the second plate 52 and positioned in a water droplet or dumbbell shape (see FIG. 15) in which damage or permanent deformation may be reduced.

According to the embodiment of the disclosure, in the folded state of the foldable electronic device 1, the first plate 51 and the second plate 52 may support the third display area 153 of the first display module 15. The third display area 153 may be provided between the first plate 51 and the second plate 52, supported by the first plate 51 and the second plate 52, and disposed in a bent shape (e.g., a water droplet shape or a dumbbell shape) in which bending stress and/or buckling may be reduced.

According to the embodiment of the disclosure, the first slider 1431 of the third hinge module 143 may be coupled to the first plate 51, and the second slider 1432 of the third hinge module 143 may be coupled to the second plate 52. When an angle between the first frame 111 and the second frame 121 is changed, the position of the first plate 51 relative to the first frame 111 and the position of the second plate 52 relative to the second frame 121 are changed by operations (or state changes) of the first hinge module 141 and the second hinge module 142. Therefore, in response to this configuration, the first guide rail may be configured to guide a route along which the first slider 1431 coupled to the first plate 51 moves relative to the guide rail 1433, and the second guide rail may be configured to guide a route along which the second slider 1432 coupled to the second plate 52 moves relative to the guide rail 1433.

According to the embodiment of the disclosure, the structure, in which the third hinge module 143 disposed between the first hinge module 141 and the second hinge module 142 is coupled to the first plate 51 and the second plate 52, may reduce or prevent a phenomenon in which the first plate 51 and the second plate 52 are lifted or a phenomenon in which the first plate 51 and the second plate 52 are separated.

According to the embodiment of the disclosure, the first support plate 1111 of the first frame 111 may include a first opening (or a first hole or a first through-hole) 401. For example, the first opening 401 may be formed through a portion between the first support area 1111A and the third support area 1111B of the first support plate 1111 (see FIG. 3). The second support plate 1211 of the second frame 121 may include a second opening (or a second hole or a second through-hole) 402. For example, the second opening 402 may be formed through a portion between the second support area 1211A and the fourth support area 1211B of the second support plate 1211 (see FIG. 3).

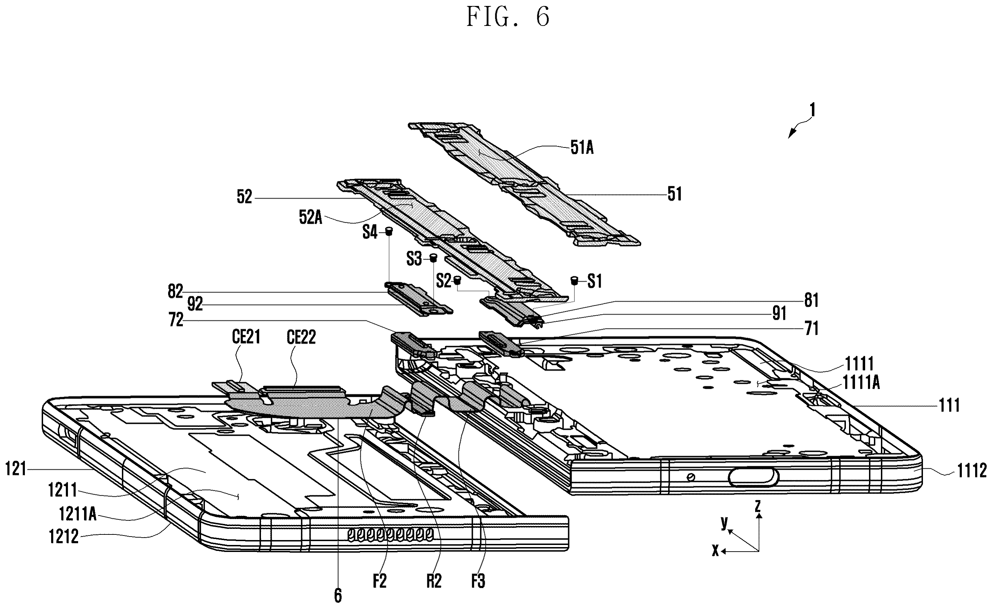

According to the embodiment of the disclosure, the foldable electronic device 1 may include a flexible printed circuit board (FPCB) (e.g., a flexible printed circuit board 6 in FIG. 6) that traverses the hinge portion 14. The flexible printed circuit board may penetrate the first opening 401 and the second opening 402.

According to the embodiment of the disclosure, the first opening 401 and the second opening 402 may overlap and be aligned with each other in the folded state of the foldable electronic device 1.

FIG. 6 is an exploded perspective view of a part of a foldable electronic device in the unfolded state according to an embodiment of the disclosure.

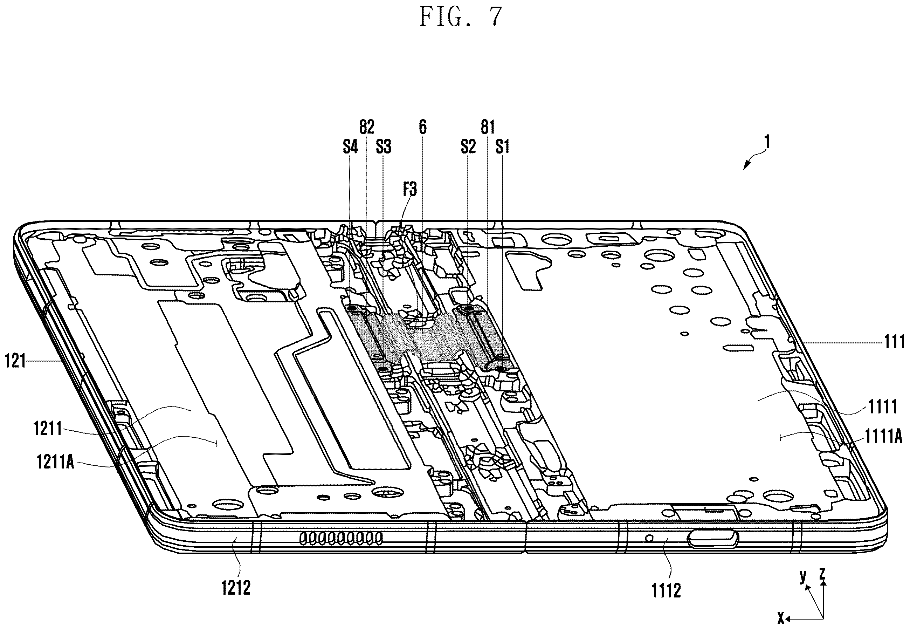

FIG. 7 is a perspective view of a part of a foldable electronic device in the unfolded state according to an embodiment of the disclosure.

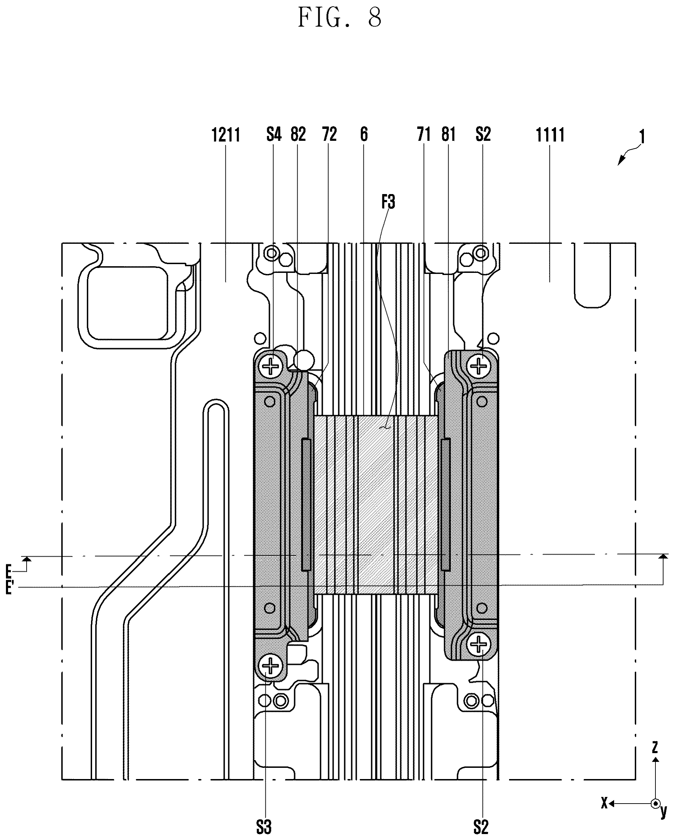

FIG. 8 is a view illustrating a part of a foldable electronic device in an unfolded state according to an embodiment of the disclosure.

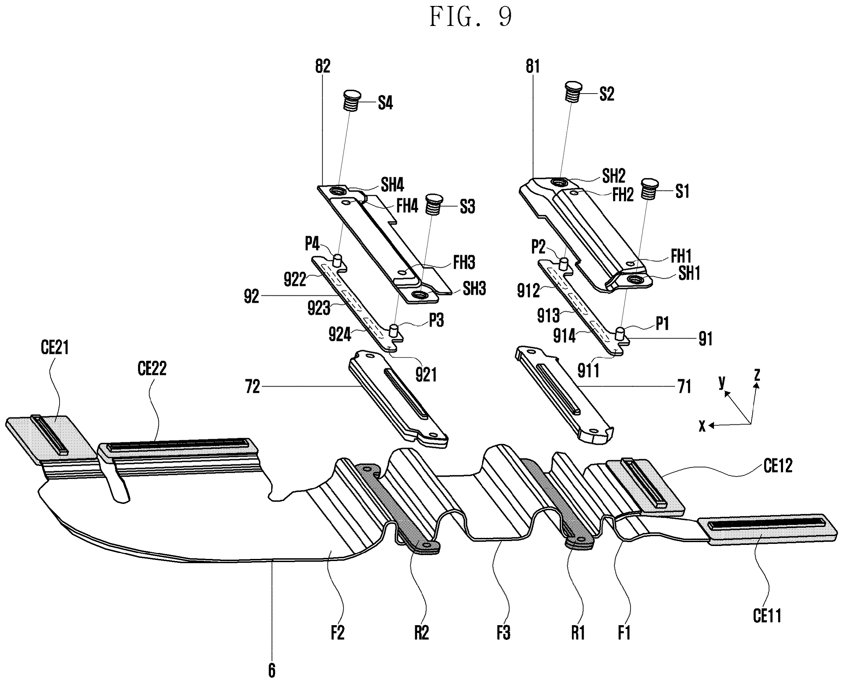

FIG. 9 is an exploded perspective view of a part of a foldable electronic device in the unfolded state according to an embodiment of the disclosure.

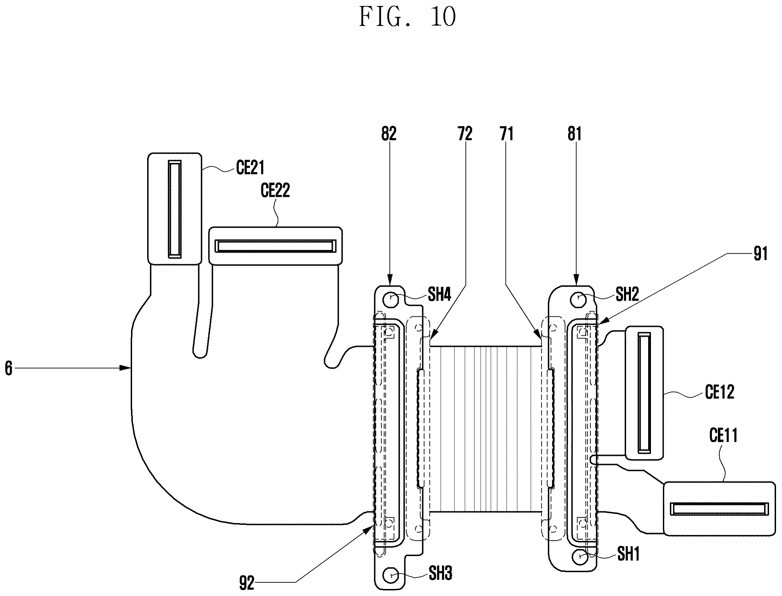

FIG. 10 is a view illustrating a part of a foldable electronic device in an unfolded state according to an embodiment of the disclosure.

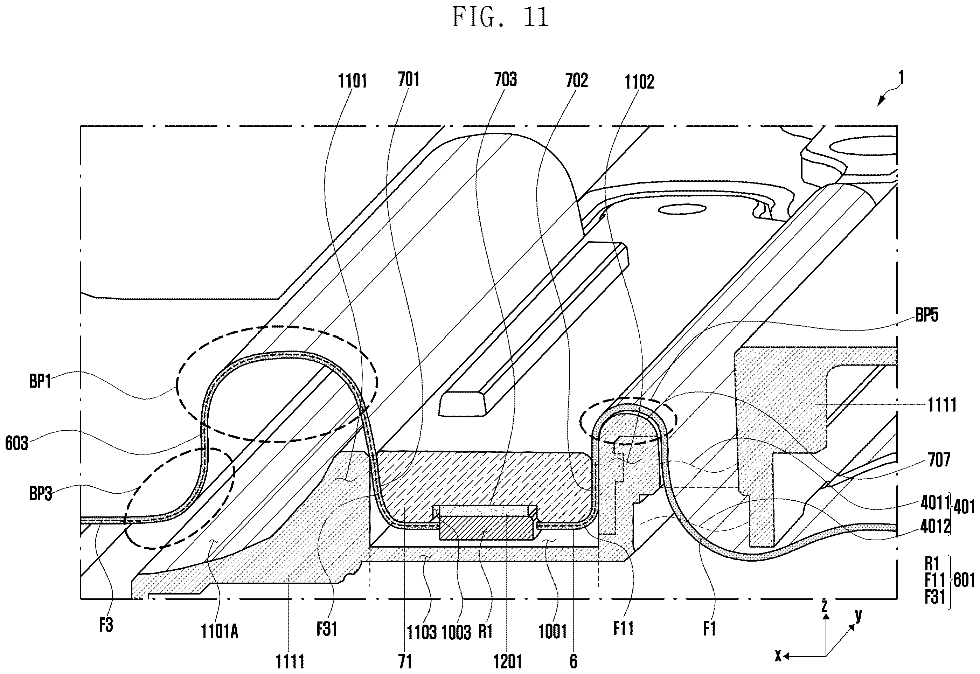

FIGS. 11, 12, and 13 are cross-sectional perspective views of a part of a foldable electronic device taken along line E-E' in FIG. 9 according to various embodiments of the disclosure.

Referring to FIGS. 6, 7, 8, 9, 10, 11, 12, and 13, the foldable electronic device 1 may include the first frame 111, the second frame 121, the first plate 51, the second plate 52, the flexible printed circuit board 6, a first support member 71, a second support member 72, a third support member 81, a fourth support member 82, a fifth support member 91, a sixth support member 92, a first seal member 1310, and/or a second seal member 1320. A description of some constituent elements denoted by the same reference numerals as the constituent elements illustrated in FIGS. 1, 2, 3, 4, and 5 will be omitted.

According to the embodiment of the disclosure, the flexible printed circuit board 6 may traverse the hinge portion 14 (see FIGS. 4 and 5).

According to the embodiment of the disclosure, the flexible printed circuit board 6 may include one or more first connector ends CE11 and CE12 and one or more second connector ends CE21 and CE22. The one or more first connector ends CE11 and CE12 may each include a first connector (e.g., a first FPCB connector). The one or more second connector ends CE21 and CE22 may each include a second connector (e.g., a second FPCB connector). The one or more first connector ends CE11 and CE12 may be positioned or accommodated in the first housing 11 (see FIG. 1) or electrically connected to at least one first element disposed on the first frame 111 (e.g., a connector on the first printed circuit board). The one or more second connector ends CE21 and CE22 may be positioned or accommodated in the second housing 12 (see FIG. 1) or electrically connected to at least one second element disposed on the second frame 121 (e.g., a connector on the second printed circuit board).

According to the embodiment of the disclosure, the flexible printed circuit board 6 may have a film shape having a thickness between board surfaces directed in opposite directions. The flexible printed circuit board 6 may include conductive patterns (also referred to as signal line patterns) (not illustrated separately) that constitute a plurality of signal lines (or electrical paths) that electrically connects the one or more first connector ends CE11 and CE12 and the one or more second connector ends CE21 and CE22. The flexible printed circuit board 6 may include conductive patterns (also referred to as ground patterns) (not illustrated separately) that constitute a ground area for reducing electromagnetic interference (EMI) related to the plurality of signal lines.

According to the embodiment of the disclosure, the one or more first connector ends CE11 and CE12 of the flexible printed circuit board 6 may be electrically connected to an electrical element such as the first printed circuit board disposed on the first frame 111. For example, the electrical element, such as the first printed circuit board, may be positioned between the first support plate 1111 and the first cover 112 (see FIG. 1) and disposed on the first support plate 1111. The electrical element, such as the first printed circuit board, may be disposed on the third support area 1111B (see FIG. 3) of the first support plate 1111.

According to the embodiment of the disclosure, the one or more second connector ends CE21 and CE22 of the flexible printed circuit board 6 may be electrically connected to an electrical element such as the second printed circuit board disposed on the second frame 121. For example, the electrical element, such as the second printed circuit board, may be positioned between the second support plate 1211 and the second cover 122 (see FIG. 1) and disposed on the second support plate 1211. The electrical element, such as the second printed circuit board, may be disposed on the fourth support area 1211B (see FIG. 3) of the second support plate 1211.

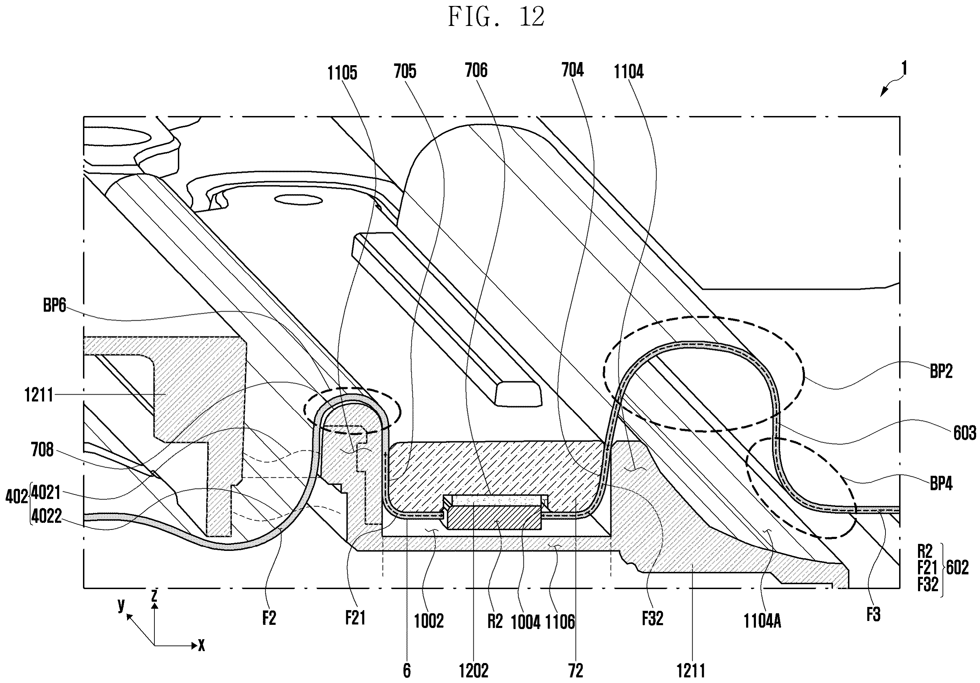

According to the embodiment of the disclosure, the flexible printed circuit board 6 may penetrate the first opening 401 (see FIG. 11) of the first support plate 1111 and the second opening 402 (see FIG. 12) of the second support plate 1211.

According to the embodiment of the disclosure, the flexible printed circuit board 6 may include a first rigid portion R1 and a second rigid portion R2. The first rigid portion R1 may be at least partially positioned between the first plate 51 and the first support plate 1111. The first rigid portion R1 may be disposed on or coupled to the first support plate 1111. The second rigid portion R2 may be at least partially positioned between the second plate 52 and the second support plate 1211. The second rigid portion R2 may be disposed on or coupled to the second support plate 1211.

According to the embodiment of the disclosure, the flexible printed circuit board 6 may include a first flexible portion F1, a second flexible portion F2, and/or a third flexible portion F3. The first flexible portion F1 may extend the one or more first connector ends CE11 and CE12 and the first rigid portion R1. The second flexible portion F2 may extend the one or more second connector ends CE21 and CE22 and the second rigid portion R2. The third flexible portion F3 may extend the first rigid portion R1 and the second rigid portion R2.

According to the embodiment of the disclosure, the first rigid portion R1 and/or the second rigid portion R2 of the flexible printed circuit board 6 may be configured to be less flexible or more rigid than the other portions (e.g., the first flexible portion F1, the second flexible portion F2, and the third flexible portion F3) of the flexible printed circuit board 6.

According to the embodiment of the disclosure, the first rigid portion R1 and/or the second rigid portion R2 may have a larger thickness than the other portions (e.g., the first flexible portion F1, the second flexible portion F2, and the third flexible portion F3) of the flexible printed circuit board 6 and thus be less flexible or more rigid than the other portions of the flexible printed circuit board 6.

According to the embodiment of the disclosure, the first rigid portion R1 and/or the second rigid portion R2 may have more laminated layers than the other portions (e.g., the first flexible portion F1, the second flexible portion F2, and the third flexible portion F3) of the flexible printed circuit board 6 and thus be less flexible or more rigid than the other portions of the flexible printed circuit board 6.

According to the embodiment of the disclosure, for example, the first rigid portion R1 may be rigid by including a first reinforcement portion (also referred to as a first reinforcement member or a first reinforcement structure) (e.g., a first reinforcement plate) such as a stiffener. For example, the second rigid portion R2 may be rigid by including a second reinforcement portion (also referred to as a second reinforcement member or a second reinforcement structure) (e.g., a second reinforcement plate) such as a stiffener.

According to the embodiment of the disclosure, the reinforcement plate included in the first rigid portion R1 and/or the second rigid portion R2 may include a layer of FR4 (or FR-4) (e.g., a glass-reinforced epoxy laminate material) or polyimide (PI). The reinforcement plate may be made of various materials.

According to the embodiment of the disclosure, the first rigid portion R1 and/or the second rigid portion R2 may be implemented to be substantially flat.

According to the embodiment of the disclosure, the flexible printed circuit board 6 may be implemented as a rigid flexible printed circuit board (rigid-flexible printed circuit board (RFPCB)). For example, the first rigid portion R1 and/or the second rigid portion R2 may be substantially rigid without the reinforcement portion.

According to the embodiment of the disclosure, the first support member 71 may be disposed on or coupled to the first support plate 1111. The first support member 71 may be configured to connect (or fix) the first rigid portion R1 of the flexible printed circuit board 6 to the first support plate 1111. The first support member 71 may also be referred to as a first support body, a first support portion, a first fixing member, a first fixing portion, or a first holder.

According to the embodiment of the disclosure, the first support member 71 may be made of a metallic material and/or a nonmetallic material.

According to the embodiment of the disclosure, the first support member 71 may be at least partially positioned between the first plate 51 and the first support plate 1111.

According to the embodiment of the disclosure, the first support member 71 may be disposed in a first recess 1001 provided (or defined) in the first support plate 1111. The first recess 1001 may be formed in the first support area 1111A (see FIGS. 6 and 7) of the first support plate 1111. For example, the first recess 1001 may have a shape recessed in a direction from the first display area 151 (see FIG. 4) toward the first cover 112 (see FIG. 1).

According to the embodiment of the disclosure, in the foldable electronic device 1 in the unfolded state, the first recess 1001 may be at least positioned between the centerline A of the foldable electronic device 1 (see FIG. 1) and the first opening 401.

According to the embodiment of the disclosure, with reference to a cross-section (see FIG. 11) of a plane perpendicular to the direction of the centerline A of the foldable electronic device 1 (see FIG. 1), the first support plate 1111 may include a first portion 1101, a second portion 1102, and a third portion 1103. The first recess 1001 may be provided (or defined) by a combination of the first portion 1101, the second portion 1102, and the third portion 1103.

According to the embodiment of the disclosure, the first portion 1101 of the first support plate 1111 may extend to the fourth rim B4 (see FIG. 1) of the first side 1112. In the unfolded state of the foldable electronic device 1, the first portion 1101 may be positioned relative to the hinge housing 13 to cover a part of the hinge housing 13 (see FIG. 4) based on the centerline A of the foldable electronic device 1. In the folded state of the foldable electronic device 1, the first portion 1101 may be positioned relative to the hinge housing 13 so as not to cover a part of the hinge housing 13 based on the centerline A of the foldable electronic device 1.

According to the embodiment of the disclosure, the hinge housing 13 (see FIG. 4) may include a third curved surface exposed to the outside in the folded state of the foldable electronic device 1 based on the centerline A of the foldable electronic device 1 (see FIG. 1), and the first portion 1101 of the first support plate 1111 may include a first curved surface 1101A corresponding to the third curved surface of the hinge housing 13.

According to the embodiment of the disclosure, the second portion 1102 of the first support plate 1111 may be spaced apart from the first portion 1101 with the first recess 1001 interposed therebetween.

According to the embodiment of the disclosure, the second portion 1102 of the first support plate 1111 may be disposed between the first recess 1001 and the first opening 401. The second portion 1102 may provide (or define) a part of the surface of the first recess 1001 and a part of the surface of the first opening 401.

According to the embodiment of the disclosure, the third portion 1103 of the first support plate 1111 may be positioned between the first support member 71 and the first cover 112 (see FIG. 1). The first portion 1101 and the second portion 1102 may protrude toward the first display area 151 (see FIG. 4) with respect to the third portion 1103.

According to the embodiment of the disclosure, the first support member 71 may include a first surface 701, a second surface 702, and/or a third surface 703. The first surface 701, the second surface 702, and the third surface 703 may face the surface of the first recess 1001 included in the first support plate 1111. The first surface 701 may substantially face the first portion 1101 of the first support plate 1111. The second surface 702 may substantially face the second portion 1102 of the first support plate 1111. The third surface 703 may substantially face the third portion 1103 of the first support plate 1111. The third surface 703 may be a surface directed in a direction opposite to the surface of the first support member 71 that faces the first plate 51.

According to the embodiment of the disclosure, the first rigid portion R1 of the flexible printed circuit board 6 may be positioned between the third surface 703 of the first support member 71 and the third portion 1103 of the first support plate 1111.

According to the embodiment of the disclosure, a first area F11 (see FIG. 11) of the first flexible portion F1 of the flexible printed circuit board 6, which extends from the first rigid portion R1, and a third area F31 (see FIG. 11) of the third flexible portion F3 of the flexible printed circuit board 6, which extends from the first rigid portion R1, may be positioned in the first recess 1001 of the first support plate 1111.

According to the embodiment of the disclosure, the first rigid portion R1, the first area F11 of the first flexible portion F1, and the third area F31 of the third flexible portion F3 may be defined or interpreted as a first fixing area 601 of the flexible printed circuit board 6 that is configured to be connected to the first support plate 1111 by the first support member 71.

According to the embodiment of the disclosure, the first fixing area 601 of the flexible printed circuit board 6 may be disposed in the first recess 1001 of the first support plate 1111 and disposed to surround the first surface 701, the second surface 702, and the third surface 703 of the first support member 71.

According to the embodiment of the disclosure, the first recess 1001 of the first support plate 1111 may be provided (or formed) so that a combination of the first support member 71 and the first fixing area 601 of the flexible printed circuit board 6 may be stably fitted with the first recess 1001.

According to the embodiment of the disclosure, the first rigid portion R1 of the first fixing area 601 may be disposed on or coupled to the third surface 703 of the first support member 71. The first rigid portion R1 may be coupled to the first support member 71 by means of a first adhesive material (or a first bonding material) 1201 disposed between the first support member 71 and the first rigid portion R1. Although not illustrated separately, the first rigid portion R1 may be coupled to the first support member 71 by mechanical fastening such as screw-fastening.

According to the embodiment of the disclosure, a space between the first support member 71 and the surface of the first recess 1001 may be disposed in a shape in which the first area F11 and the third area F31 of the first fixing area 601 reduce bending stress or bending stress is not concentrated on at least one portion.

According to the embodiment of the disclosure, the third surface 703 of the first support member 71 may include a third recess 1003. The first adhesive material 1201 may be positioned in the third recess 1003. For example, the first rigid portion R1 of the first fixing area 601 may be at least partially inserted into the third recess 1003.

According to the embodiment of the disclosure, in case that the first support member 71, to which the first rigid portion R1 is coupled, is inserted into the first recess 1001, the first fixing area 601 may be substantially disposed along the first surface 701, the second surface 702, and the third surface 703 of the first support member 71 or substantially tightly attached to the first support member 71 by a combination of the first support member 71 and the surface of the first recess 1001.

According to the embodiment of the disclosure, when the first support member 71 is inserted into the first recess 1001 and the first fixing area 601 is substantially tightly attached to the first support member 71, the third recess 1003 may reduce the occurrence of stress between the first rigid portion R1 and the first area F11 and/or between the first rigid portion R1 and the third area F31 because of the configuration in which the first rigid portion R1 is thicker than the first area F11 and the third area F31.

According to the embodiment of the disclosure, when the first support member 71 is inserted into the first recess 1001 and the first fixing area 601 is substantially tightly attached to the first support member 71, the first surface 701 and the third surface 703 of the first support member 71 may be connected through a smoothly curved surface in order to reduce bending stress occurring in the first area F11 of the first fixing area 601.

According to the embodiment of the disclosure, when the first support member 71 is inserted into the first recess 1001 and the first fixing area 601 is substantially tightly attached to the first support member 71, the second surface 702 and the third surface 703 of the first support member 71 may be connected through a smoothly curved surface in order to reduce bending stress occurring in the third area F31 of the first fixing area 601.

According to the embodiment of the disclosure, the second support member 72 may be disposed on or coupled to the second support plate 1211. The second support member 72 may be configured to connect (or fix) the second rigid portion R2 of the flexible printed circuit board 6 to the second support plate 1211. The second support member 72 may also be referred to as a second support body, a second support portion, a second fixing member, a second fixing portion, or a second holder.

According to the embodiment of the disclosure, the second support member 72 may be made of a metallic material and/or a nonmetallic material.

According to the embodiment of the disclosure, the second support member 72 may be at least partially positioned between the second plate 52 and the second support plate 1211.

According to the embodiment of the disclosure, the second support member 72 may be disposed in a second recess 1002 provided (or defined) in the second support plate 1211. The second recess 1002 may be formed in the second support area 1211A (see FIGS. 6 and 7) of the second support plate 1211. For example, the second recess 1002 may have a shape recessed in a direction from the second display area 152 (see FIG. 4) toward the second cover 122 (see FIG. 1).

According to the embodiment of the disclosure, in the foldable electronic device 1 in the unfolded state, the second recess 1002 may be at least positioned between the centerline A of the foldable electronic device 1 (see FIG. 1) and the second opening 402.

According to the embodiment of the disclosure, in the unfolded state of the foldable electronic device 1, the first recess 1001 may be at least partially positioned between the second recess 1002 and the first opening 401. In the unfolded state of the foldable electronic device 1, the second recess 1002 may be at least partially positioned between the first recess 1001 and the second opening 402.

According to the embodiment of the disclosure, the first recess 1001 and the second recess 1002 may be aligned with and overlap each other in the folded state of the foldable electronic device 1.

According to the embodiment of the disclosure, with reference to a cross-section (see FIG. 12) of the plane perpendicular to the direction of the centerline A of the foldable electronic device 1 (see FIG. 1), the second support plate 1211 may include a fourth portion 1104, a fifth portion 1105, and a sixth portion 1106. The second recess 1002 may be provided (or defined) by a combination of the fourth portion 1104, the fifth portion 1105, and the sixth portion 1106.

According to the embodiment, of the disclosure the fourth portion 1104 of the second support plate 1211 may extend to the eighth rim B8 (see FIG. 1) of the second side 1212. In the unfolded state of the foldable electronic device 1, the fourth portion 1104 may be positioned relative to the hinge housing 13 to cover a part of the hinge housing 13 (see FIG. 4) based on the centerline A of the foldable electronic device 1. In the folded state of the foldable electronic device 1, the fourth portion 1104 may be positioned relative to the hinge housing 13 so as not to cover a part of the hinge housing 13 based on the centerline A of the foldable electronic device 1.

According to the embodiment of the disclosure, the hinge housing 13 (see FIG. 4) may include a fourth curved surface exposed to the outside in the folded state of the foldable electronic device 1 based on the centerline A of the foldable electronic device 1 (see FIG. 1), and the fourth portion 1104 of the second support plate 1211 may include a second curved surface 1104A corresponding to the fourth curved surface of the hinge housing 13.

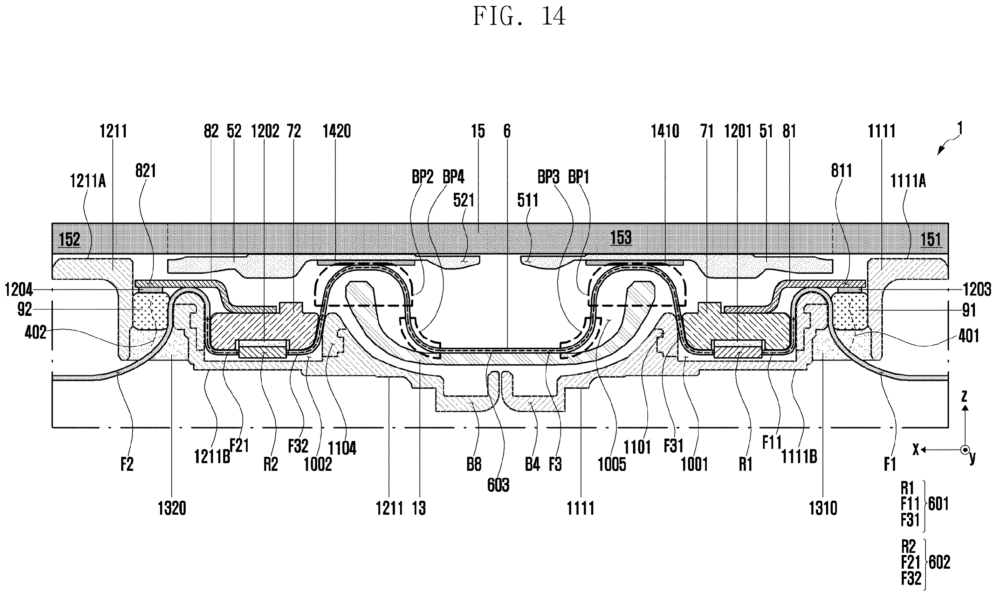

According to the embodiment of the disclosure, a combination of the first curved surface 1101A of the first support plate 1111 and the second curved surface 1104A of the second support plate 1211 may provide (or define) a recess in which the hinge housing 13 (see FIG. 14) is positioned in the unfolded state of the foldable electronic device 1.

According to the embodiment of the disclosure, the fifth portion 1105 of the second support plate 1211 may be spaced apart from the fourth portion 1104 with the second recess 1002 interposed therebetween.

According to the embodiment of the disclosure, the fifth portion 1105 of the second support plate 1211 may be disposed between the second recess 1002 and the second opening 402. The fifth portion 1105 may provide (or define) a part of the surface of the second recess 1002 and a part of the surface of the second opening 402.

According to the embodiment of the disclosure, the sixth portion 1106 of the second support plate 1211 may be positioned between the second support member 72 and the second cover 122 (see FIG. 1). The fourth portion 1104 and the fifth portion 1105 may protrude toward the second display area 152 (see FIG. 4) with respect to the sixth portion 1106.

According to the embodiment of the disclosure, the second support member 72 may include a fourth surface 704, a fifth surface 705, and/or a sixth surface 706. The fourth surface 704, the fifth surface 705, and the sixth surface 706 may face the surface of the second recess 1002 included in the second support plate 1211. The fourth surface 704 may substantially face the fourth portion 1104 of the second support plate 1211. The fifth surface 705 may substantially face the fifth portion 1105 of the second support plate 1211. The sixth surface 706 may substantially face the sixth portion 1106 of the second support plate 1211. The sixth surface 706 may be a surface directed in a direction opposite to the surface of the second support member 72 that faces the second plate 52.

According to the embodiment of the disclosure, the second rigid portion R2 of the flexible printed circuit board 6 may be positioned between the sixth surface 706 of the second support member 72 and the sixth portion 1106 of the second support plate 1211.

According to the embodiment of the disclosure, a second area F21 (see FIG. 12) of the second flexible portion F2 of the flexible printed circuit board 6, which extends from the second rigid portion R2, and a fourth area F32 (see FIG. 12) of the third flexible portion F3 of the flexible printed circuit board 6, which extends from the second rigid portion R2, may be positioned in the second recess 1002 of the second support plate 1211.

According to the embodiment of the disclosure, the second rigid portion R2, the second area F21 of the second flexible portion F2, and the fourth area F32 of the third flexible portion F3 may be defined or interpreted as a second fixing area 602 of the flexible printed circuit board 6 that is configured to be connected to the second support plate 1211 by the second support member 72.

According to the embodiment of the disclosure, the second fixing area 602 of the flexible printed circuit board 6 may be disposed in the second recess 1002 of the second support plate 1211 and disposed to surround the fourth surface 704, the fifth surface 705, and the sixth surface 706 of the second support member 72.

According to the embodiment of the disclosure, the second recess 1002 of the second support plate 1211 may be provided (or formed) so that a combination of the second support member 72 and the second fixing area 602 of the flexible printed circuit board 6 may be stably fitted with the second recess 1002.

According to the embodiment of the disclosure, the second rigid portion R2 of the second fixing area 602 may be disposed on or coupled to the sixth surface 706 of the second support member 72. The second rigid portion R2 may be coupled to the second support member 72 by means of a second adhesive material (or a second bonding material) 1202 disposed between the second support member 72 and the second rigid portion R2. Although not illustrated separately, the second rigid portion R2 may be coupled to the second support member 72 by mechanical fastening such as screw-fastening.

According to the embodiment of the disclosure, a space between the second support member 72 and the surface of the second recess 1002 may be disposed in a shape in which the second area F21 and the fourth area F32 of the second fixing area 602 reduce bending stress or bending stress is not concentrated on at least one portion.

According to the embodiment of the disclosure, the sixth surface 706 of the second support member 72 may include a fourth recess 1004. The second adhesive material 1202 may be positioned in the fourth recess 1004. For example, the second rigid portion R2 of the second fixing area 602 may be at least partially inserted into the fourth recess 1004.

According to the embodiment of the disclosure, in case that the second support member 72, to which the second rigid portion R2 is coupled, is inserted into the second recess 1002, the second fixing area 602 may be substantially disposed along the fourth surface 704, the fifth surface 705, and the sixth surface 706 of the second support member 72 or substantially tightly attached to the second support member 72 by a combination of the second support member 72 and the surface of the second recess 1002.

According to the embodiment of the disclosure, when the second support member 72 is inserted into the second recess 1002 and the second fixing area 602 is substantially tightly attached to the second support member 72, the fourth recess 1004 may reduce the occurrence of stress between the second rigid portion R2 and the second area F21 and/or between the second rigid portion R2 and the fourth area F32 because of the configuration in which the second rigid portion R2 is thicker than the second area F21 and the fourth area F32.

According to the embodiment of the disclosure, when the second support member 72 is inserted into the second recess 1002 and the second fixing area 602 is substantially tightly attached to the second support member 72, the fourth surface 704 and the sixth surface 706 of the second support member 72 may be connected through a smoothly curved surface in order to reduce bending stress occurring in the second area F21 of the second fixing area 602.

According to the embodiment of the disclosure, when the second support member 72 is inserted into the second recess 1002 and the second fixing area 602 is substantially tightly attached to the second support member 72, the fifth surface 705 and the sixth surface 706 of the second support member 72 may be connected through a smoothly curved surface in order to reduce bending stress occurring in the fourth area F32 of the second fixing area 602.

According to the embodiment of the disclosure, the first fixing area 601 may be connected or fixed to the first support plate 1111 by means of the first support member 71, and/or the second fixing area 602 may be connected or fixed to the second support plate 1211 by means of the second support member 72, such that a bendable area 603 of the third flexible portion F3 of the flexible printed circuit board 6, which substantially performs a motion when the foldable electronic device 1 is changed between the unfolded state and the folded state, may be determined. The bendable area 603 may extend the first fixing area 601 and the second fixing area 602 of the third flexible portion F3 of the flexible printed circuit board 6. The bendable area 603 may have a length within a designated range.

According to the embodiment of the disclosure, when the foldable electronic device 1 is changed between the unfolded state and the folded state, the relative position between the first fixing area 601 and the second fixing area 602 of the flexible printed circuit board 6 may be changed. The bendable area 603 of the flexible printed circuit board 6 may be disposed in a shape corresponding to a relative position between the first fixing area 601 and the second fixing area 602.

According to the embodiment of the disclosure, the bendable area 603 of the flexible printed circuit board 6 has a length within a designated range, such that the bendable area 603 may not interfere with each other in the folded state of the foldable electronic device 1. The bendable area 603 of the flexible printed circuit board 6 has the length within the designated range, which makes it easy to dispose the bendable area 603 in a designated shape in the unfolded state and the folded state of the foldable electronic device 1. The designated shape in which the bendable area 603 is disposed may reduce or prevent damage to the bendable area 603 in the unfolded state and the folded state of the foldable electronic device 1.

According to the embodiment of the disclosure, in the unfolded state, the foldable electronic device 1 may provide (or define) a first relative position between the first fixing area 601 and the second fixing area 602. In the folded state, the foldable electronic device 1 may provide (or define) a second relative position between the first fixing area 601 and the second fixing area 602. In the unfolded state, the foldable electronic device 1 may provide (or define) a first internal space in which the bendable area 603 of the flexible printed circuit board 6 is disposed. In the folded state, the foldable electronic device 1 may provide (or define) a second internal space in which the bendable area 603 of the flexible printed circuit board 6 is disposed. In the unfolded state of the foldable electronic device 1, the bendable area 603 of the flexible printed circuit board 6 may be disposed in a first shape designated to correspond to the first internal space and the first relative position between the first fixing area 601 and the second fixing area 602. The designated first shape may reduce interference with surrounding constituent elements while reducing or preventing damage to the bendable area 603 of the flexible printed circuit board in the unfolded state of the foldable electronic device 1. In the folded state of the foldable electronic device 1, the bendable area 603 of the flexible printed circuit board 6 may be disposed in a designated second shape corresponding to the second internal space and the second relative position between the first fixing area 601 and the second fixing area 602. The designated second shape may reduce interference with surrounding constituent elements while reducing or preventing damage to the bendable area 603 of the flexible printed circuit board 6 in the folded state of the foldable electronic device 1.

According to the embodiment of the disclosure, the bendable area 603 of the flexible printed circuit board 6 may be disposed in a designated shape by being supported by the first plate 51, the second plate 52, and the hinge housing 13 (see FIG. 14) in the unfolded state of the foldable electronic device 1.

According to the embodiment of the disclosure, in the unfolded state of the foldable electronic device 1, the designated shape in which the bendable area 603 of the flexible printed circuit board 6 is disposed may include a first bending portion BP1, a second bending portion BP2, a third bending portion BP3, and a fourth bending portion BP4.

According to the embodiment of the disclosure, the first bending portion BP1 may be a first curve that passes over the first portion 1101 of the first support plate 1111 so as to extend from the first fixing area 601 to a fifth recess 1005 (see FIG. 14) of the hinge housing 13. In the unfolded state of the foldable electronic device 1, the fifth recess 1005 of the hinge housing 13 may be configured to provide a space in which the bendable area 603 of the flexible printed circuit board 6 is accommodated, and a surface of the fifth recess 1005 may be configured to support the bendable area 603.

According to the embodiment of the disclosure, the first plate 51 may support the first bending portion BP1.

According to the embodiment of the disclosure, the first bending portion BP1 may be directly (or physically) in contact with the first plate 51 so that the first bending portion BP1 may be supported by the first plate 51.

According to the embodiment of the disclosure, the first bending portion BP1 may be indirectly in contact with the first plate 51 so that the first bending portion BP1 is supported by the first plate 51. The configuration in which the first bending portion BP1 is indirectly in contact with the first plate 51 may be defined or interpreted as a configuration in which the first bending portion BP1 and the first plate 51 are in contact with each other through at least one medium between the first bending portion BP1 and the first plate 51. For example, the first bending portion BP1 may be physically in contact with a separate member (e.g., a first film 1410 in FIG. 14) disposed on the first plate 51.

According to the embodiment of the disclosure, the second bending portion BP2 may be a second curve that passes over the fourth portion 1104 of the second support plate 1211 so as to extend from the second fixing area 602 to the fifth recess 1005 (see FIG. 14) of the hinge housing 13.

According to the embodiment of the disclosure, the second plate 52 may support the second bending portion BP2.

According to the embodiment of the disclosure, the second bending portion BP2 may be directly (or physically) in contact with the second plate 52 so that the second bending portion BP2 is supported by the second plate 52.

According to the embodiment of the disclosure, the second bending portion BP2 may be indirectly in contact with the second plate 52 so that the second bending portion BP2 is supported by the second plate 52. The configuration in which the second bending portion BP2 is indirectly in contact with the second plate 52 may be defined or interpreted as a configuration in which the second bending portion BP2 and the second plate 52 are in contact with each other through at least one medium. For example, the second bending portion BP2 may be physically in contact with a separate member (e.g., a second film 1420 in FIG. 14) disposed on the second plate 52.

According to the embodiment of the disclosure, the third bending portion BP3 and the fourth bending portion BP4 may be provided (or defined) as a part of the bendable area 603, which extends the first bending portion BP1 and the second bending portion BP2, is positioned in the fifth recess 1005 (see FIG. 14) of the hinge housing 13 and supported by the surface of the fifth recess 1005. The third bending portion BP3 may extend the first bending portion BP1 and the fourth bending portion BP4 and be positioned at one side of the hinge housing 13 (see FIG. 14). The fourth bending portion BP4 may extend the second bending portion BP2 and the third bending portion BP3 and be positioned at the other side of the hinge housing 13 (see FIG. 14).

According to the embodiment of the disclosure, in the unfolded state of the foldable electronic device 1, the bendable area 603 of the flexible printed circuit board 6 may be provided (or formed) to be substantially symmetric with respect to the centerline A of the foldable electronic device 1 (see FIG. 1). For example, the first bending portion BP1 and the second bending portion BP2 may be substantially symmetric with respect to the centerline A of the foldable electronic device 1 (see FIG. 1). For example, the third bending portion BP3 and the fourth bending portion BP4 may be substantially symmetric with respect to the centerline A of the foldable electronic device 1 (see FIG. 1).

According to the embodiment of the disclosure, in the unfolded state of the foldable electronic device 1, bending stress may occur on the first bending portion BP1, the second bending portion BP2, the third bending portion BP3, and the fourth bending portion BP4 included in the bendable area 603 of the flexible printed circuit board 6. The third flexible portion F3 of the flexible printed circuit board 6 may have a thickness between one surface and the other surface positioned opposite to each other, and the bending stress, which occurs on the bending portions (e.g., the first bending portion BP1, the second bending portion BP2, the third bending portion BP3, and the fourth bending portion BP4), may occur when a force (e.g., tensile stress), which stretches one surface of the bending portion, and a force (e.g., compressive stress), which contracts the other surface of the bending portion, collide with each other. The bending stress, which may occur on the bending portions (e.g., the first bending portion BP1, the second bending portion BP2, the third bending portion BP3, and the fourth bending portion BP4) of the bendable area 603 in the unfolded state of the foldable electronic device 1, may be proportional to a longitudinal elastic modulus (e.g., a degree of resistance against tension or compression) of the third flexible portion F3 and/or a thickness of the third flexible portion F3. The bending stress, which may occur on the bending portions (e.g., the first bending portion BP1, the second bending portion BP2, the third bending portion BP3, and the fourth bending portion BP4) of the bendable area 603 in the unfolded state of the foldable electronic device 1, may be inversely proportional to a radius of curvature. In the unfolded state of the foldable electronic device 1, the first bending portion BP1, the second bending portion BP2, the third bending portion BP3, and the fourth bending portion BP4 of the bendable area 603 may define a radius of curvature larger than a threshold radius of curvature in order to reduce damage to the bendable area 603. For example, in the case of the comparative example in which the bending portion has a radius of curvature smaller than the threshold radius of curvature, bending stress (e.g., yield stress), which causes damage to or permanent deformation of the bending portion, may occur. For example, in the case of the comparative example in which the bending portion has a radius of curvature smaller than the threshold radius of curvature, bending stress, which occurs on the bending portion when the foldable electronic device repeatedly is changed between the unfolded state and the folded state, causes a decrease or loss of an elastic force due fatigue accumulation, which may result in damage to or permanent deformation of the bending portion.

According to the embodiment of the disclosure, in the unfolded state of the foldable electronic device 1, the first display module 15 (see FIG. 14) may be disposed flat in a first direction when viewed in the direction of the centerline A of the foldable electronic device 1 (see FIG. 1). In the folded state of the foldable electronic device 1, the first display area 151 and the second display area 152 of the first display module 15 may face each other. In the folded state of the foldable electronic device 1, when viewed in the direction of the centerline A of the foldable electronic device 1 (see FIG. 1), the hinge portion 14 (see FIG. 4) may be configured such that the first plate 51 defines a first acute angle with respect to a second direction and the second plate 52 defines a second acute angle with respect to the second direction so that a space between the first plate 51 and the second plate 52 increases in the second direction perpendicular to the first direction. The second direction may be a direction directed from the first and second display areas 151 and 152 (see FIG. 15), which face each other, toward the third display area 153 (see FIG. 15) in the folded state of the foldable electronic device 1. The first acute angle and the second acute angle may be substantially equal to each other. In the folded state of the foldable electronic device 1, the first plate 51 and the second plate 52 may define an acute angle. In the folded state, the third flexible portion F3 of the flexible printed circuit board 6 may be longer to prevent interference with the first plate 51 and the second plate 52 in the foldable electronic device 1 of the disclosure in comparison with a foldable electronic device (not illustrated separately) of a first comparative example in which the first plate 51 and the second plate 52 are disposed to be substantially parallel to each other. There may be a foldable electronic device (not illustrated separately) of a second comparative example in which the entire third flexible portion F3 substantially performs a motion during the transition between the unfolded state and the folded state. In the unfolded state of the foldable electronic device of the second comparative example, the entire third flexible portion F3 needs to be positioned in a designated internal space of the foldable electronic device. For this reason, a bending portion of at least any one of the third flexible portions F3 is likely to have a radius of curvature smaller than the threshold radius of curvature, which may cause damage to or permanent deformation of the bending portion. According to the foldable electronic device 1 of the disclosure, the bendable area 603 of the third flexible portion F3, which has a designated length, is determined by the first support member 71 and the second support member 72, which may reduce or prevent damage to the flexible printed circuit board 6, in comparison with the foldable electronic device of the second comparative example.

According to the embodiment of the disclosure, the shape, in which the third area F31 included in the first fixing area 601 of the third flexible portion F3 extends between the first support member 71 (or the first surface 701) and the first portion 1101 of the first support plate 1111, may assist in disposing the bendable area 603 of the third flexible portion F3 in a designated shape when the foldable electronic device 1 is changed from the folded state to the unfolded state.

According to the embodiment of the disclosure, the shape, in which the third area F31 included in the first fixing area 601 of the third flexible portion F3 extends between the first support member 71 (or the first surface 701) and the first portion 1101 of the first support plate 1111, may reduce stress that may occur between the third area F31 and the bendable area 603 when the foldable electronic device 1 is changed between the unfolded state and the folded state. The shape, in which the third area F31 extends between the first support member 71 (or the first surface 701) and the first portion 1101 of the first support plate 1111, may reduce a degree to which stress is concentrated between the third area F31 and the bendable area 603 in the unfolded state of the foldable electronic device 1.

According to the embodiment of the disclosure, the shape, in which the fourth area F32 included in the second fixing area 602 of the third flexible portion F3 extends between the second support member 72 (or the fourth surface 704) and the fourth portion 1104 of the second support plate 1211, may assist in disposing the bendable area 603 of the third flexible portion F3 in a designated shape when the foldable electronic device 1 is changed from the folded state to the unfolded state.

According to the embodiment of the disclosure, the shape, in which the fourth area F32 included in the second fixing area 602 of the third flexible portion F3 extends between the second support member 72 (or the fourth surface 704) and the fourth portion 1104 of the second support plate 1211, may reduce stress that may occur between the fourth area F32 and the bendable area 603 when the foldable electronic device 1 is changed between the unfolded state and the folded state. The shape, in which the fourth area F32 extends between the second support member 72 (or the fourth surface 704) and the fourth portion 1104 of the second support plate 1211, may reduce a degree to which stress is concentrated between the fourth area F32 and the bendable area 603 in the unfolded state of the foldable electronic device 1.

According to the embodiment of the disclosure, the first surface 701 of the first support member 71 may include a first inclined surface. The fourth surface 704 of the second support member 72 may include a second inclined surface. The first inclined surface may be configured to support the third area F31 of the first fixing area 601. The second inclined surface may be configured to support the fourth area F32 of the second fixing area 602. For example, the first inclined surface may define a first obtuse angle with respect to the third surface 703 of the first support member 71 on which the first rigid portion R1 of the first fixing area 601 is disposed. For example, the second inclined surface may define a second obtuse angle with respect to the sixth surface 706 of the second support member 72 on which the second rigid portion R2 of the second fixing area 602 is disposed. The first obtuse angle and the second obtuse angle may be substantially equal to each other. For example, the first inclined surface and the second inclined surface may be disposed to be substantially symmetric with respect to the centerline A of the foldable electronic device 1. Because the first plate 51 and the second plate 52 are operatively connected to at least one hinge module (e.g., the first hinge module 141, the second hinge module 142, and the third hinge module 143 in FIG. 4), a first angle between the first inclined surface and the first plate 51 and a second angle between the second inclined surface and the second plate 52 may be changed when the foldable electronic device 1 is changed between the unfolded state and the folded state. The first angle and the second angle may be substantially equal to each other.

According to the embodiment of the disclosure, the third area F31 of the third flexible portion F3 of the flexible printed circuit board 6, which is included in the first fixing area 601, may be disposed along the first inclined surface of the first surface 701 of the first support member 71 or supported by the first inclined surface. The fourth area F32 of the third flexible portion F3 of the flexible printed circuit board 6, which is included in the second fixing area 602, may be disposed along the second inclined surface of the fourth surface 704 of the second support member 72 or supported by the second inclined surface. The first inclined surface and the second inclined surface may assist in disposing the bendable area 603 of the third flexible portion F3 in a designated shape when the foldable electronic device 1 is changed from the folded state to the unfolded state. The first inclined surface and the second inclined surface may reduce stress, which may occur between the bendable area 603 and the third area F31 of the first fixing area 601, and stress, which may occur between the bendable area 603 and the fourth area F32 of the second fixing area 602, when the foldable electronic device 1 is changed between the unfolded state and the folded state. The first inclined surface and the second inclined surface may reduce a degree to which stress is concentrated between the bendable area 603 and the third area F31 of the first fixing area 601 and between the bendable area 603 and the fourth area F32 of the second fixing area 602 in the unfolded state of the foldable electronic device 1.

According to various embodiments of the disclosure, although not illustrated separately, when viewed in the direction of the centerline A of the foldable electronic device 1 (see FIG. 1) in the unfolded state, the first inclined surface of the first surface 701 of the first support member 71 and the second inclined surface of the fourth surface 704 of the second support member 72 may each be provided (or defined) as a curved surface.

According to various embodiments of the disclosure, although not illustrated separately, when viewed in the direction of the centerline A of the foldable electronic device 1 (see FIG. 1) in the unfolded state, the first surface 701 of the first support member 71 and the fourth surface 704 of the second support member 72 may be substantially parallel to each other and directed in the direction perpendicular to the centerline A.

According to the embodiment of the disclosure, the third support member 81 may be at least partially positioned between the first support member 71 and the first plate 51. The third support member 81 may be coupled to the first support plate 1111. For example, the third support member 81 may be coupled to the first support plate 1111 by means of a first screw S1 and a second screw S2. The third support member 81 may include a first screw hole SH1 corresponding to the first screw S1, and a second screw hole SH2 corresponding to the second screw S2.

According to the embodiment of the disclosure, the third support member 81 may be supported by screw-fastened first support plate 1111 and press the first support member 71 toward the first recess 1001 so that the first support member 71 is not withdrawn from the first recess 1001 of the first support plate 1111.

According to the embodiment of the disclosure, the fourth support member 82 may be at least partially positioned between the second support member 72 and the second plate 52. The fourth support member 82 may be coupled to the second support plate 1211. For example, the fourth support member 82 may be coupled to the second support plate 1211 by means of a third screw S3 and a fourth screw S4. The fourth support member 82 may include a third screw hole SH3 corresponding to the third screw S3, and a fourth screw hole SH4 corresponding to the fourth screw S4.

According to the embodiment of the disclosure, the fourth support member 82 may be supported by the screw-fastened second support plate 1211 and press the second support member 72 toward the second recess 1002 so that the second support member 72 is not withdrawn from the second recess 1002 of the second support plate 1211.

According to the embodiment of the disclosure, the third support member 81 and/or the fourth support member 82 may be made of a metallic material and/or a nonmetallic material.

According to the embodiment of the disclosure, the third support member 81 and the fourth support member 82 may be aligned with and overlap each other in the folded state of the foldable electronic device 1.

According to the embodiment of the disclosure, the fifth support member 91 may be disposed on or coupled to the third support member 81. For example, the fifth support member 91 may be coupled to the third support member 81 by means of a third adhesive material (or a third bonding material) 1203 disposed between the third support member 81 and the fifth support member 91.

According to the embodiment of the disclosure, the fifth support member 91 may include a first protruding portion P1 and/or a second protruding portion P2. The third support member 81 may include a first fixing hole (also referred to as a third hole) FH1 corresponding to the first protruding portion P1, and/or a second fixing hole (also referred to as a fourth hole) FH2 corresponding to the second protruding portion P2. The first protruding portion P1 may be inserted into the first fixing hole FH1. The second protruding portion P2 may be inserted into the second fixing hole FH2. A combination of the first protruding portion P1 and the first fixing hole FH1 and/or a combination of the second protruding portion P2 and the second fixing hole FH2 may improve coupling between the third support member 81 and the fifth support member 91. A combination of the first protruding portion P1 and the first fixing hole FH1 and/or a combination of the second protruding portion P2 and the second fixing hole FH2 may guide a position at which the fifth support member 91 is coupled with respect to the third support member 81.

According to the embodiment of the disclosure, the first flexible portion F1 of the flexible printed circuit board 6 may be fixed to the first support plate 1111 by means of the fifth support member 91.

According to the embodiment of the disclosure, the fifth support member 91 may include a first insert (also referred to as a first insertion protrusion or a first extension portion) 911 inserted into the first opening 401 of the first support plate 1111. The first insert 911 may be inserted into the first opening 401 by being supported by a part 811 of the first support member 71 that is positioned to correspond to the first opening 401.

According to the embodiment of the disclosure, when the third support member 81, to which the fifth support member 91 is coupled, is coupled to the first support plate 1111 by screw-fastening, the first insert 911 of the fifth support member 91 may be inserted into the first opening 401 of the first support plate 1111. The first insert 911 of the fifth support member 91 may substantially tightly attach the first flexible portion F1 of the flexible printed circuit board 6, which penetrates the first opening 401 of the first support plate 1111, to the second portion 1102 of the first support plate 1111. The first flexible portion F1 of the flexible printed circuit board 6, which penetrates the first opening 401, may be fixed to the second portion 1102 of the first support plate 1111 by means of the first insert 911 of the fifth support member 91 positioned in the first opening 401.

According to the embodiment of the disclosure, the first flexible portion F1 may be pulled by the first insert 911 and fixed to the second portion 1102 when the first insert 911 is inserted into the first opening 401 of the first support plate 1111 in order to reduce a gap between the first flexible portion F1 of the flexible printed circuit board 6 and the first support member 71 and/or a gap between the first flexible portion F1 of the flexible printed circuit board 6 and the second portion 1102 of the first support plate 1111.

According to the embodiment of the disclosure, the second portion 1102 of the first support plate 1111 may include a seventh surface 707 configured to extend the surface of the first recess 1001 and the surface of the first opening 401. The first flexible portion F1 of the flexible printed circuit board 6 may have a fifth bending portion BP5 corresponding to the seventh surface 707. The seventh surface 707 may be provided (or defined) as a curved surface that smoothly connects the surface of the first recess 1001 and the surface of the first opening 401 in order to reduce bending stress of the fifth bending portion BP5.

According to the embodiment of the disclosure, the first opening 401 of the first support plate 1111 may include a first portion opening area 4011 and a second portion opening area 4012. The first portion opening area 4011 may be positioned between the second portion opening area 4012 and the first display area 151 (see FIG. 14). The second portion opening area 4012 may be positioned between the first portion opening area 4011 and the first cover 112 (see FIG. 1). The first portion opening area 4011 and the second portion opening area 4012 may overlap and be connected to each other.

According to the embodiment of the disclosure, when viewed from above the first cover 112 (see FIG. 1), the second portion opening area 4012 of the first opening 401 may be provided (or formed) to have a larger width than the first portion opening area 4011 of the first opening 401.

According to the embodiment of the disclosure, the first insert 911 of the fifth support member 91 may be positioned in the first portion opening area 4011 of the first opening 401 and tightly attach the first flexible portion F1 of the flexible printed circuit board 6 to the surface of the first portion opening area 4011.

According to the embodiment of the disclosure, the fifth support member 91 may be substantially rigid.

According to the embodiment of the disclosure, the fifth support member 91 may be made of a metallic material and/or a nonmetallic material.

According to the embodiment of the disclosure, the fifth support member 91 may include an elastic member or a flexible member. For example, the fifth support member 91 may include rubber or silicone. The first insert 911 of the fifth support member 91 may be resiliently disposed in the first portion opening area 4011 of the first opening 401.

According to the embodiment of the disclosure, the first insert 911 of the fifth support member 91 may be expanded to a part of the second portion opening area 4012 of the first opening 401. For example, the first insert 911 may include one or more protruding portions 912, 913, and 914 expanded to the second portion opening area 4012.

According to the embodiment of the disclosure, the first seal member 1310 may be disposed in the first opening 401 of the first support plate 1111. A combination of the first opening 401 of the first support plate 1111 and the first insert 911 of the fifth support member 91 positioned in the first opening 401 may provide (or form) a recess in which the first seal member 1310 may be disposed.

According to the embodiment of the disclosure, the first seal member 1310 may be formed by filling the first opening 401 of the first support plate 1111 with an adhesive material (e.g., a liquid adhesive material such as cured-in place gaskets (CIPG)) and then curing the adhesive material (e.g., curing the adhesive material by a photoreaction or a thermal reaction).

According to various embodiments of the disclosure, the first seal member 1310 may include various polymer adhesive or bonding materials.

According to the embodiment of the disclosure, the first flexible portion F1 of the flexible printed circuit board 6 may be connected (or fixed) to the first support plate 1111 through the first seal member 1310.

According to the embodiment of the disclosure, the first insert 911 of the fifth support member 91 may reduce or prevent a leak of the adhesive material into the space between the first support plate 1111 and the first display area 151 (see FIG. 1) when the first opening 401 of the first support plate 1111 is filled with the adhesive material for the first seal member 1310.

According to the embodiment of the disclosure, the foldable electronic device 1 may include a first waterproof area (also referred to as a first waterproof space) and a second waterproof area (also referred to as a second waterproof space). The first waterproof area may be a space between the first frame 111 and the first display area 151 (see FIG. 1). The second waterproof area may be a space between the first support plate 1111 and the first cover 112 (see FIG. 1). A plurality of electrical constituent elements may be positioned in the first waterproof area and the second waterproof area. The first seal member 1310 disposed in the first opening 401 may separate the first waterproof area and the second waterproof area. The first seal member 1310 may reduce or prevent a situation in which foreign substances (e.g., moisture and/or dust), which are introduced into the foldable electronic device 1 from the outside, flow (or move) from the first waterproof area to the second waterproof area or flow (or move) from the second waterproof area to the first waterproof area through the first opening 401. For example, the first seal member 1310 may include a waterproof member or a waterproof material.

According to the embodiment of the disclosure, the sixth support member 92 may be disposed on or coupled to the fourth support member 82. For example, the sixth support member 92 may be coupled to the fourth support member 82 by means of a fourth adhesive material (or a fourth bonding material) 1204 disposed between the fourth support member 82 and the sixth support member 92.

According to the embodiment of the disclosure, the sixth support member 92 may include a third protruding portion P3 and/or a fourth protruding portion P4. The fourth support member 82 may include a third fixing hole (also referred to as a fifth hole) FH3 corresponding to the third protruding portion P3, and/or a fourth fixing hole (also referred to as a sixth hole) FH4 corresponding to the fourth protruding portion P4. The third protruding portion P3 may be inserted into the third fixing hole FH3. The fourth protruding portion P4 may be inserted into the fourth fixing hole FH4. A combination of the third protruding portion P3 and the third fixing hole FH3 and/or a combination of the fourth protruding portion P4 and the fourth fixing hole FH4 may improve coupling between the fourth support member 82 and the sixth support member 92. A combination of the third protruding portion P3 and the third fixing hole FH3 and/or a combination of the fourth protruding portion P4 and the fourth fixing hole FH4 may guide a position at which the sixth support member 92 is coupled with respect to the fourth support member 82.

According to the embodiment of the disclosure, the second flexible portion F2 of the flexible printed circuit board 6 may be fixed to the second support plate 1211 by means of the sixth support member 92.

According to the embodiment of the disclosure, the sixth support member 92 may include a second insert (also referred to as a second insertion protrusion or a second extension portion) 921 inserted into the second opening 402 of the second support plate 1211. The second insert 921 may be inserted into the second opening 402 by being supported by a part 821 of the fourth support member 82 that is positioned to correspond to the second opening 402.

According to the embodiment of the disclosure, when the fourth support member 82, to which the sixth support member 92 is coupled, is coupled to the second support plate 1211 by screw-fastening, the second insert 921 of the sixth support member 92 may be inserted into the second opening 402 of the second support plate 1211. The second insert 921 of the sixth support member 92 may substantially and tightly attach the second flexible portion F2 of the flexible printed circuit board 6, which penetrates the second opening 402 of the second support plate 1211, to the fifth portion 1105 of the second support plate 1211. The second flexible portion F2 of the flexible printed circuit board 6, which penetrates the second opening 402, may be fixed to the fifth portion 1105 of the second support plate 1211 by means of the second insert 921 of the sixth support member 92 positioned in the second opening 402.

According to the embodiment of the disclosure, the second flexible portion F2 may be pulled by the second insert 921 and fixed to the fifth portion 1105 when the second insert 921 is inserted into the second opening 402 of the second support plate 1211 in order to reduce a gap between the second flexible portion F2 of the flexible printed circuit board 6 and the second support member 72 and/or a gap between the second flexible portion F2 of the flexible printed circuit board 6 and the fifth portion 1105 of the second support plate 1211.

According to the embodiment of the disclosure, the fifth portion 1105 of the second support plate 1211 may include an eighth surface 708 configured to extend the surface of the second recess 1002 and the surface of the second opening 402. The second flexible portion F2 of the flexible printed circuit board 6 may have a sixth bending portion BP6 corresponding to the eighth surface 708. The eighth surface 708 may be provided (or defined) as a curved surface that smoothly connects the surface of the second recess 1002 and the surface of the second opening 402 in order to reduce bending stress of the sixth bending portion BP6.

According to the embodiment of the disclosure, the second opening 402 of the second support plate 1211 may include a third portion opening area 4021 and a fourth portion opening area 4022. The third portion opening area 4021 may be positioned between the fourth portion opening area 4022 and the second display area 152 (see FIG. 14). The fourth portion opening area 4022 may be positioned between the third portion opening area 4021 and the second cover 122 (see FIG. 1). The third portion opening area 4021 and the fourth portion opening area 4022 may overlap and be connected to each other.

According to the embodiment of the disclosure, when viewed from above the second cover 122 (see FIG. 1), the fourth portion opening area 4022 of the second opening 402 may be provided (or formed) to have a larger width than the third portion opening area 4021 of the second opening 402.

According to the embodiment of the disclosure, the second insert 921 of the sixth support member 92 may be positioned in the third portion opening area 4021 of the second opening 402 and tightly attach the second flexible portion F2 of the flexible printed circuit board 6 to the surface of the third portion opening area 4021.

According to the embodiment, the sixth support member 92 may be substantially rigid.

According to the embodiment of the disclosure, the sixth support member 92 may be made of a metallic material and/or a nonmetallic material.

According to the embodiment of the disclosure, the sixth support member 92 may include an elastic member or a flexible member. For example, the sixth support member 92 may include rubber or silicone. The second insert 921 of the sixth support member 92 may be resiliently disposed in the third portion opening area 4021 of the second opening 402.

According to the embodiment of the disclosure, the second insert 921 of the sixth support member 92 may be expanded to a part of the fourth portion opening area 4022 of the second opening 402. For example, the second insert 921 may include one or more protruding portions 922, 923, and 924 expanded to the fourth portion opening area 4022.

According to the embodiment of the disclosure, the second seal member 1320 may be disposed in the second opening 402 of the second support plate 1211. A combination of the second opening 402 of the second support plate 1211 and the sixth support member 92 positioned in the second opening 402 may provide (or form) a recess in which the second seal member 1320 may be disposed.

According to the embodiment of the disclosure, the second seal member 1320 may be formed by filling the second opening 402 of the second support plate 1211 with an adhesive material (e.g., a liquid adhesive material such as CIPG) and then curing the adhesive material (e.g., curing the adhesive material by a photoreaction or a thermal reaction).

According to various embodiments of the disclosure, the second seal member 1320 may include various polymer adhesive or bonding materials.

According to the embodiment of the disclosure, the second flexible portion F2 of the flexible printed circuit board 6 may be connected (or fixed) to the second support plate 1211 through the second seal member 1320.

According to the embodiment of the disclosure, the second insert 921 of the sixth support member 92 may reduce or prevent a leak of the adhesive material into the space between the second support plate 1211 and the second display area 152 (see FIG. 1) when the second opening 402 of the second support plate 1211 is filled with the adhesive material for the second seal member 1320.

According to the embodiment of the disclosure, the foldable electronic device 1 may include a third waterproof area (also referred to as a third waterproof space) and a fourth waterproof area (also referred to as a fourth waterproof space). The third waterproof area may be a space between the second frame 121 and the second display area 152 (see FIG. 1). The fourth waterproof area may be a space between the second support plate 1211 and the second cover 122 (see FIG. 1). A plurality of electrical constituent elements may be positioned in the third waterproof area and the fourth waterproof area. The second seal member 1320 disposed in the second opening 402 may separate the third waterproof area and the fourth waterproof area. The second seal member 1320 may reduce or prevent a situation in which foreign substances (e.g., moisture and/or dust), which are introduced into the foldable electronic device 1 from the outside, flow (or move) from the third waterproof area to the fourth waterproof area or flow (or move) from the fourth waterproof area to the third waterproof area through the second opening 402. For example, the second seal member 1320 may include a waterproof member or a waterproof material.

According to the embodiment of the disclosure, a combination of the first support member 71, the third support member 81, and the fifth support member 91, which are disposed on or coupled to the first support plate 1111, may be configured so as not to interfere with the motion of the first plate 51 operatively connected to the one or more hinge modules (e.g., the first hinge module 141, the second hinge module 142, and the fourth hinge module 143 in FIG. 4) when the foldable electronic device 1 is changed between the unfolded state and the folded state.

According to the embodiment of the disclosure, a combination of the second support member 72, the fourth support member 82, and the sixth support member 92, which are disposed on or coupled to the second support plate 1211, may be configured so as not to interfere with the motion of the second plate 52 operatively connected to the one or more hinge modules (e.g., the first hinge module 141, the second hinge module 142, and the fourth hinge module 143 in FIG. 4) when the foldable electronic device 1 is changed between the unfolded state and the folded state.

According to various embodiments of the disclosure, although not illustrated separately, it is possible to provide (or form) an integrated or single support member (e.g., a single continuous structure or a complete structure) substituted for the first support member 71 and the third support member 81.

According to various embodiments of the disclosure, although not illustrated separately, it is possible to provide (or form) an integrated or single support member (e.g., a single continuous structure or a complete structure) substituted for the third support member 81 and the fifth support member 91.

According to various embodiments of the disclosure, although not illustrated separately, it is possible to provide (or form) an integrated or single support member (e.g., a single continuous structure or a complete structure) substituted for the first support member 71, the third support member 81, and the fifth support member 91.

According to various embodiments of the disclosure, although not illustrated separately, it is possible to provide (or form) an integrated or single support member (e.g., a single continuous structure or a complete structure) substituted for the second support member 72 and the fourth support member 82.

According to various embodiments of the disclosure, although not illustrated separately, it is possible to provide (or form) an integrated or single support member (e.g., a single continuous structure or a complete structure) substituted for the fourth support member 82 and the sixth support member 92.

According to various embodiments of the disclosure, although not illustrated separately, it is possible to provide (or form) an integrated or single support member (e.g., a single continuous structure or a complete structure) substituted for the second support member 72, the fourth support member 82, and the sixth support member 92.

FIG. 14 is a cross-sectional view of a part of a foldable electronic device taken along line E-E' in FIG. 9 according to an embodiment of the disclosure.

FIG. 15 is a cross-sectional view of a part of a foldable electronic device in a folded state according to the embodiment of the disclosure.

Referring to FIGS. 14 and 15, the foldable electronic device 1 may include the first support plate 1111, the second support plate 1211, the flexible printed circuit board 6, the first support member 71, the second support member 72, the third support member 81, the fourth support member 82, the fifth support member 91, the sixth support member 92, the first adhesive material 1201, the second adhesive material 1202, the third adhesive material 1203, the fourth adhesive material 1204, the first display module 15, the first plate (or the first wing plate) 51, the second plate (or the second wing plate) 52, the first seal member 1310, the second seal member 1320, the first film 1410, and/or the second film 1420. A description of some constituent elements denoted by the same reference numerals as the constituent elements illustrated in FIGS. 6, 7, 8, 9, 10, 11, 12, and 13 will be omitted.

Referring to FIGS. 14 and 15, when the foldable electronic device 1 is changed from the unfolded state to the folded state, the first plate 51 and the second plate 52, which are operatively connected to the one or more hinge modules (e.g., the first hinge module 141, the second hinge module 142, and the third hinge module 143 in FIG. 4), may define an acute angle. When the foldable electronic device 1 is changed from the unfolded state to the folded state, the space between the first plate 51 and the second plate 52 may be provided as a shape that enlarges toward the hinge housing 13 so that the third display area 153 of the first display module 15 may be disposed in a bent shape (e.g., a water droplet shape or a dumbbell shape) in which bending stress and/or buckling may be reduced.

According to the embodiment of the disclosure, in the folded state of the foldable electronic device 1, the third display area 153 of the first display module 15 may be positioned between the first plate 51 and the second plate 52. In the folded state of the foldable electronic device 1, the third display area 153 may be provided between the first plate 51 and the second plate 52, supported by the first plate 51 and the second plate 52, and disposed in a bent shape (e.g., a water droplet shape or a dumbbell shape) in which bending stress and/or buckling may be reduced.

According to the embodiment of the disclosure, the flexible printed circuit board 6 may include the first rigid portion R1, the second rigid portion R2, the first flexible portion F1, the second flexible portion F2, and/or the third flexible portion F3.

According to the embodiment of the disclosure, the flexible printed circuit board 6 may have the first fixing area 601 including the first rigid portion R1, the first area F11 of the first flexible portion F1, and the third area F31 of the third flexible portion F3. The first fixing area 601 may be connected or fixed to the first support plate 1111 as the first support member 71 is disposed in the first recess 1001 of the first support plate 1111. The first fixing area 601 may be provided in the first recess 1001 and disposed between the first support member 71 and the first support plate 1111. The first fixing area 601 may be provided in the first recess 1001 and surround the first support member 71. For example, the first fixing area 601 may be provided in the first recess 1001 and at least surround a partial surface of the first support member 71 (e.g., bottom and side surfaces of the first support member 71). The bottom surface of the first support member 71 may include the third surface 703 in FIG. 11, and the side surface of the first support member 71 may include the first surface 701 and the second surface 702 in FIG. 11. For example, the first fixing area 601 may not at least surround a partial surface of the first support member 71 (e.g., a top surface of the first support member 71) in the first recess 1001. The top surface of the first support member 71 may be positioned opposite to the bottom surface of the first support member 71 and directed toward the first plate 51.

According to the embodiment of the disclosure, the flexible printed circuit board 6 may have the second fixing area 602 including the second rigid portion R2, the second area F21 of the second flexible portion F2, and the fourth area F32 of the third flexible portion F3. The second fixing area 602 may be connected or fixed to the second support plate 1211 as the second support member 72 is disposed in the second recess 1002 of the second support plate 1211. The second fixing area 602 may be provided in the second recess 1002 and disposed between the second support member 72 and the second support plate 1211. The second fixing area 602 may be provided in the second recess 1002 and surround the second support member 72. For example, the second fixing area 602 may be provided in the second recess 1002 and at least surround a partial surface of the second support member 72 (e.g., bottom and side surfaces of the second support member 72). The bottom surface of the second support member 72 may include the sixth surface 706 in FIG. 12, and the side surface of the second support member 72 may include the fourth surface 704 and the fifth surface 705 in FIG. 12. For example, the second fixing area 602 may not at least surround a partial surface of the second support member 72 (e.g., a top surface of the second support member 72) in the second recess 1002. The top surface of the second support member 72 may be positioned opposite to the bottom surface of the second support member 72 and directed toward the second plate 52.

According to the embodiment of the disclosure, because the first fixing area 601 of the flexible printed circuit board 6 is disposed in the first recess 1001 of the first support plate 1111 and the second fixing area 602 of the flexible printed circuit board 6 is disposed in the second recess 1002 of the second support plate 1211, the bendable area 603 of the third flexible portion F3 of the flexible printed circuit board 6, which substantially performs a motion when the foldable electronic device 1 is changed between the unfolded state and the folded state, may be determined.

According to the embodiment of the disclosure, the bendable area 603 of the flexible printed circuit board 6 may penetrate the first opening 401 of the first support plate 1111 and penetrate the second opening 402 of the second support plate 1211.

According to the embodiment of the disclosure, the bendable area 603 of the flexible printed circuit board 6 may have a length within a designated range. The bendable area 603 has the length within the designated range, such that the bendable area 603 may not interfere with the first plate 51 and the second plate 52 in the folded state of the foldable electronic device 1. The bendable area 603 has the length within the designated range, such that the bendable area 603 may be disposed in a designated shape in the unfolded state and the folded state of the foldable electronic device 1. The designated shape, in which the bendable area 603 is disposed in the unfolded state and the folded state of the foldable electronic device 1, may reduce stress, which may occur in the bendable area 603, and reduce or prevent damage to the bendable area 603.

According to the embodiment of the disclosure, when the foldable electronic device 1 is changed between the unfolded state and the folded state, the relative position between the first fixing area 601 and the second fixing area 602 of the flexible printed circuit board 6 and the internal space, in which the bendable area 603 of the flexible printed circuit board 6 is disposed, may be changed. The bendable area 603 of the flexible printed circuit board 6 may be disposed in a designated shape in which interference with surrounding constituent elements and stress may be reduced when the foldable electronic device 1 is changed between the unfolded state and the folded state.

According to the embodiment of the disclosure, in the unfolded state of the foldable electronic device 1, the bendable area 603 of the flexible printed circuit board 6 may be disposed in a designated shape having the first bending portion BP1, the second bending portion BP2, the third bending portion BP3, and the fourth bending portion BP4.

According to the embodiment of the disclosure, the shape, in which the third area F31 included in the first fixing area 601 of the third flexible portion F3 extends between the first support member 71 and the first portion 1101 of the first support plate 1111, and the shape, in which the fourth area F32 included in the second fixing area 602 of the third flexible portion F3 extends between the second support member 72 and the fourth portion 1104 of the second support plate 1211, may assist in disposing the bendable area 603 of the third flexible portion F3 in a designated shape when the foldable electronic device 1 is changed from the folded state to the unfolded state. In the folded state of the foldable electronic device 1, the bendable area 603 of the flexible printed circuit board 6 may have a first pre-bending portion 1501 by being supported by the first plate 51 by the shape in which the third area F31 included in the first fixing area 601 extends between the first support member 71 and the first portion 1101 of the first support plate 1111. The first pre-bending portion 1501 may allow the first bending portion BP1 to be smoothly formed when the foldable electronic device 1 is changed from the folded state to the unfolded state. In the folded state of the foldable electronic device 1, the bendable area 603 of the flexible printed circuit board 6 may have a second pre-bending portion 1502 by being supported by the second plate 52 by the shape in which the fourth area F32 included in the second fixing area 602 extends between the second support member 72 and the fourth portion 1104 of the second support plate 1211. The second pre-bending portion 1502 may allow the second bending portion BP2 to be smoothly formed when the foldable electronic device 1 is changed from the folded state to the unfolded state.

According to the embodiment of the disclosure, when the foldable electronic device 1 is changed from the folded state to the unfolded state, the bendable area 603 of the flexible printed circuit board 6 may be disposed in a designated shape having the first bending portion BP1, the second bending portion BP2, the third bending portion BP3, and the fourth bending portion BP4 by a combination of first deformation and second deformation. For example, when the foldable electronic device 1 is changed from the folded state to the unfolded state, the first deformation of the bendable area 603 may include deformation from the first pre-bending portion 1501 to the first bending portion BP1 and deformation from the second pre-bending portion 1502 to the second bending portion BP2. For example, when the foldable electronic device 1 is changed from the folded state to the unfolded state, the second deformation of the bendable area 603 may include a situation in which the remaining portion of the bendable area 603, which extends the first pre-bending portion 1501 and the second pre-bending portion 1502, enters the fifth recess 1005 of the hinge housing 13 and is deformed to the third bending portion BP3 and the fourth bending portion BP4 while being supported by the surface of the fifth recess 1005. The first deformation and the second deformation of the bendable area 603 may be performed operatively or in conjunction with each other.

According to the embodiment of the disclosure, the fifth recess 1005 of the hinge housing 13 may be configured to provide a space in which the bendable area 603 of the flexible printed circuit board 6 is accommodated in the unfolded state of the foldable electronic device 1, and the surface of the fifth recess 1005 may be configured to support the bendable area 603 so that the bendable area 603 has the third bending portion BP3 and the fourth bending portion BP4. The fifth recess 1005 of the hinge housing 13 may be positioned between the first recess 1001 of the first support plate 1111 and the second recess 1002 of the second support plate 1211 in the unfolded state of the foldable electronic device 1.

According to the embodiment of the disclosure, the fifth recess 1005 of the hinge housing 13, which corresponds to the bendable area 603 of the flexible printed circuit board 6, may be positioned between the seventh recess 132 (see FIG. 4) and the eighth recess 133 (see FIG. 4) of the hinge housing 13. In various embodiments of the disclosure, the fifth recess 1005 of the hinge housing 13, which corresponds to the bendable area 603 of the flexible printed circuit board 6, may be positioned between the sixth recess 131 (see FIG. 4) and the eighth recess 133 (see FIG. 4) of the hinge housing 13.

According to the embodiment of the disclosure, in the folded state of the foldable electronic device 1, the portion of the bendable area 603 of the flexible printed circuit board 6, which extends the first pre-bending portion 1501 and the second pre-bending portion 1502, may be positioned to be spaced apart from the hinge housing 13. In the folded state of the foldable electronic device 1, the portion of the bendable area 603, which extends the first pre-bending portion 1501 and the second pre-bending portion 1502, may be supported by the first plate 51 and the second plate 52 and maintained in a designated shape convex toward the hinge housing 13.

According to the embodiment of the disclosure, a first end 511 of the first plate 51 and a second end 521 of the second plate 52 may face each other in the unfolded state of the foldable electronic device 1. The first end 511 of the first plate 51 and the second end 521 of the second plate 52 are further spaced apart from each other in the folded state of the foldable electronic device 1 than in the unfolded state of the foldable electronic device 1. The bendable area 603 of the flexible printed circuit board 6 may be supported by the first end 511 of the first plate 51 and the second end 521 of the second plate 52 in the folded state of the foldable electronic device 1. The first end 511 of the first plate 51 may include a first curved surface 5111 configured to support the bendable area 603 in order to assist in disposing and maintaining the bendable area 603 in a designated shape while reducing stress occurring in the bendable area 603 in the folded state of the foldable electronic device 1. The second end 521 of the second plate 52 may include a second curved surface 5211 configured to support the bendable area 603 in order to assist in disposing and maintaining the bendable area 603 in a designated shape while reducing stress occurring in the bendable area 603 in the folded state of the foldable electronic device 1.

According to the embodiment of the disclosure, the first film 1410 may be disposed on the first plate 51. The second film 1420 may be disposed on the second plate 52.

According to the embodiment of the disclosure, the bendable area 603 of the flexible printed circuit board 6 may be in contact with the first film 1410 and supported by the first plate 51 on which the first film 1410 is disposed. The bendable area 603 of the flexible printed circuit board 6 may be in contact with the second film 1420 and supported by the second plate 52 on which the second film 1420 is disposed. In the unfolded state of the foldable electronic device 1, the bendable area 603 of the flexible printed circuit board 6 may have the first bending portion BP1 by being in contact with the first film 1410 and supported by the first plate 51 on which the first film 1410 is disposed. In the unfolded state of the foldable electronic device 1, the bendable area 603 of the flexible printed circuit board 6 may have the second bending portion BP2 by being in contact with the second film 1420 and supported by the second plate 52 on which the second film 1420 is disposed. In the folded state of the foldable electronic device 1, the bendable area 603 of the flexible printed circuit board 6 may have the first pre-bending portion 1501 by being in contact with the first film 1410 and supported by the first plate 51 on which the first film 1410 is disposed. In the folded state of the foldable electronic device 1, the bendable area 603 of the flexible printed circuit board 6 may have the second pre-bending portion 1502 by being in contact with the second film 1420 and supported by the second plate 52 on which the second film 1420 is disposed.

According to the embodiment of the disclosure, the bendable area 603 of the flexible printed circuit board 6 may be in sliding contact with the first film 1410 disposed on the first plate 51 and the second film 1420 disposed on the second plate 52 while the foldable electronic device 1 is changed between the unfolded state and the folded state. The first film 1410 may prevent the bendable area 603 of the flexible printed circuit board 6 from being in direct contact with the first plate 51, thereby reducing a frictional force between the bendable area 603 and the first plate 51. The second film 1420 may prevent the bendable area 603 of the flexible printed circuit board 6 from being in direct contact with the second plate 52, thereby reducing a frictional force between the bendable area 603 and the second plate 52. The first film 1410 and the second film 1420 may be made of a material (e.g., a lubricating material) capable of reducing a frictional force with the bendable area 603 of the flexible printed circuit board 6 so that the bendable area 603 of the flexible printed circuit board 6 may smoothly perform the motion when the foldable electronic device 1 is changed between the unfolded state and the folded state. The first film 1410 and the second film 1420 may reduce or prevent a frictional sound between the bendable area 603 of the flexible printed circuit board 6 and the first plate 51 and a frictional sound between the bendable area 603 of the flexible printed circuit board 6 and the second plate 52.

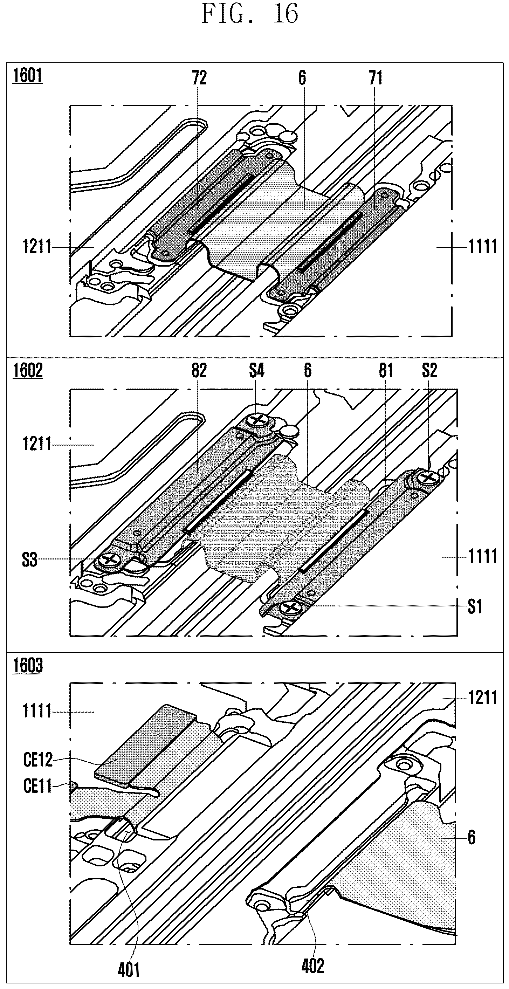

FIG. 16 is a view illustrating operations of connecting a flexible printed circuit board to a first support plate and a second support plate according to an embodiment of the disclosure.

Referring to FIG. 16, at operation 1601, the first support member 71 may be coupled to the first rigid portion R1 (see FIGS. 14 and 15) of the flexible printed circuit board 6 by means of the first adhesive material 1201 (see FIGS. 14 and 15). At operation 1601, the second support member 72 may be coupled to the second rigid portion R2 (see FIGS. 14 and 15) of the flexible printed circuit board 6 by means of the second adhesive material 1202 (see FIGS. 14 and 15). At operation 1601, the flexible printed circuit board 6 may penetrate the first opening 401 of the first support plate 1111 and the second opening 402 of the second support plate 1211 and be positioned on the first support plate 1111 and the second support plate 1211.

At operation 1601, the first support member 71 may be inserted into the first recess 1001 (see FIGS. 14 and 15) of the first support plate 1111. A part of the flexible printed circuit board 6, which includes the first rigid portion R1, may be the first fixing area 601 (see FIGS. 14 and 15) provided in the first recess 1001, disposed between the first support member 71 and the first support plate 1111, and connected to the first support plate 1111. The first fixing area 601 may be provided in the first recess 1001 and surround the first support member 71.

At operation 1601, the second support member 72 may be inserted into the second recess 1002 (see FIGS. 14 and 15) of the second support plate 1211. A part of the flexible printed circuit board 6, which includes the second rigid portion R2, may be the second fixing area 602 (see FIGS. 14 and 15) provided in the second recess 1002, and disposed between the second support member 72 and the second support plate 1211, and connected to the second support plate 1211. The second fixing area 602 may be provided in the second recess 1002 and surround the second support member 72.

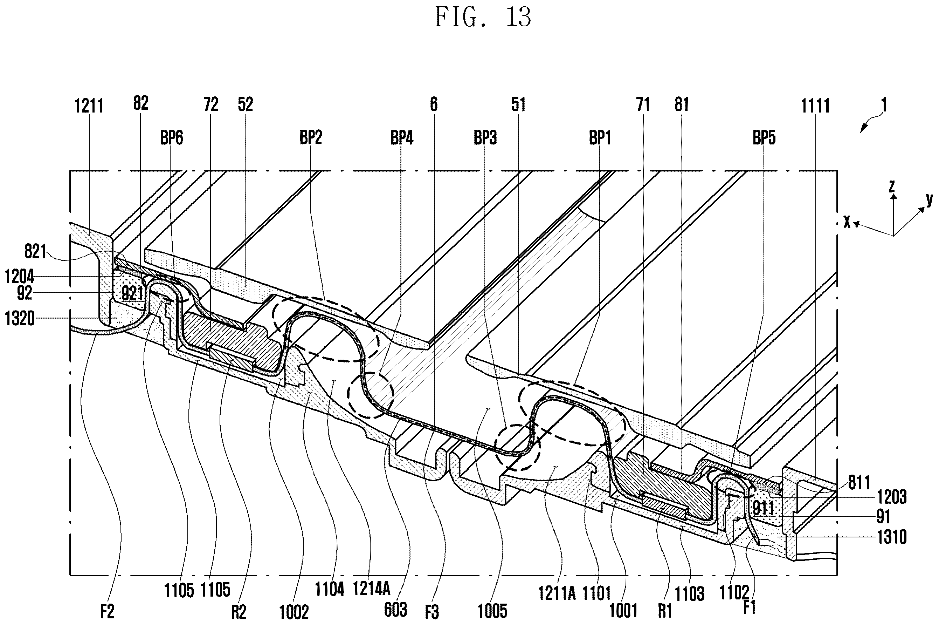

At operation 1602, a combination of the third support member 81 and the fifth support member 91 (see FIGS. 14 and 15) may be disposed on the first support plate 1111 by means of the first screw S1 and the second screw S2. The third support member 81 may press the first support member 71 toward the first recess 1001 so that the first support member 71 is not withdrawn from the first recess 1001 (see FIGS. 14 and 15) of the first support plate 1111. The first insert 911 (see FIG. 13) of the fifth support member 91 may be inserted into the first opening 401 of the first support plate 1111. The first insert 911 (see FIG. 13) of the fifth support member 91 may tightly attach the flexible printed circuit board 6, which penetrates the first opening 401, to the surface of the first opening 401.

At operation 1602, a combination of the fourth support member 82 and the sixth support member 92 (see FIGS. 14 and 15) may be disposed on the second support plate 1211 by means of the third screw S3 and the fourth screw S4. The fourth support member 82 may press the second support member 72 toward the second recess 1002 so that the second support member 72 is not withdrawn from the second recess 1002 (see FIGS. 14 and 15) of the second support plate 1211. The second insert 921 (see FIG. 13) of the sixth support member 92 may be inserted into the second opening 402 of the second support plate 1211. The second insert 921 (see FIG. 13) of the sixth support member 92 may tightly attach the flexible printed circuit board 6, which penetrates the second opening 402, to the surface of the second opening 402.

At operation 1603, the first seal member 1310 (see FIGS. 14 and 15) may be formed by filling the first opening 401 of the first support plate 1111 with an adhesive material (e.g., CIPG) and then curing the adhesive material. The first insert 911 (see FIG. 13) of the fifth support member 91 (see FIGS. 14 and 15) may reduce or prevent a leak of the adhesive material into the space between the first support plate 1111 and the first display area 151 (see FIGS. 14 and 15). The flexible printed circuit board 6, which penetrates the first opening 401, may be connected to the first support plate 1111 by means of the first seal member 1310.

At operation 1603, the second seal member 1320 (see FIGS. 14 and 15) may be formed by filling the second opening 402 of the second support plate 1211 with an adhesive material (e.g., CIPG) and then curing the adhesive material. The second insert 921 (see FIG. 13) of the sixth support member 92 (see FIGS. 14 and 15) may reduce or prevent a leak of the adhesive material into the space between the second support plate 1211 and the second display area 152 (see FIGS. 14 and 15). The flexible printed circuit board 6, which penetrates the second opening 402, may be connected to the second support plate 1211 by means of the second seal member 1320.

According to an example embodiment of the disclosure, the foldable electronic device 1 may include the foldable housing 10, the flexible printed circuit board 6, the first support member 71, and/or the second support member 72. The foldable housing 10 may include the first housing 11, the second housing 12, and the hinge portion 14 configured to connect the first housing 11 and the second housing 12. The flexible printed circuit board 6 may extend across the hinge portion 14. The first support member 71 may be configured to connect the flexible printed circuit board 6 to the first housing 11. The second support member 72 may be configured to connect the flexible printed circuit board 6 to the second housing 12. The hinge portion 14 may include the first plate 51 and the second plate 52. The hinge portion 14 may be configured such that the first plate 51 and the second plate 52 face each other when the foldable housing 10 is changed from the unfolded state to the folded state. The first support member 71 may be positioned between the first plate 51 and the first housing 11 and disposed in the first recess 1001 formed on the first housing 11. The first fixing area 601 of the flexible printed circuit board 6 may be disposed between the first support member 71 and the first housing 11 to surround the first support member 71 in the first recess 1001. The second support member 72 may be positioned between the second plate 52 and the second housing 12 and disposed in the second recess 1002 formed on the second housing 12. The second fixing area 602 of the flexible printed circuit board 6 may be disposed between the second support member 72 and the second housing 12 to surround the second support member 72 in the second recess 1002.

According to an example embodiment of the disclosure, the foldable electronic device 1 may further include the flexible display module (e.g., the first display module 15) disposed in the foldable housing 10. The flexible display module may include the first display area 151 disposed in the first housing 11, the second display area 152 disposed in the second housing 12, and the third display area 153 configured to extend the first display area 151 and the second display area 152. In the folded state of the foldable housing 10, the first display area 151 and the second display area 152 may face each other, and the third display area 153 may be curved. The hinge portion 14 may be configured such that the first plate 51 and the second plate 52 support the third display area 153 so that the third display area 153 is flat in the unfolded state of the foldable housing 10. The hinge portion 14 may be configured such that the first plate 51 and the second plate 52 face each other with the third display area 153 interposed therebetween in the folded state of the foldable housing 10.

According to an example embodiment of the disclosure, the flexible display module (e.g., the first display module 15) may be disposed to be flat in the first direction in the unfolded state of the foldable housing 10 when viewed in the direction of the folding axis (e.g., the centerline A) of the foldable housing 10. The hinge portion 14 may be configured such that the first plate 51 and the second plate 52 defines an acute angle in the second direction, which is perpendicular to the first direction and directed from the first and second display areas 151 and 152 toward the third display area 153, in the unfolded state of the foldable housing 10 when viewed in the direction of the folding axis. The space between the first plate 51 and the second plate 52 may increase in the second direction.

According to an example embodiment of the disclosure, the first recess 1001 and the second recess 1002 may be aligned with and overlap each other in the folded state of the foldable housing 10.

According to an example embodiment of the disclosure, the flexible printed circuit board 6 may include the first rigid portion R1, the second rigid portion R2, the one or more first connector ends CE11 and CE12, the one or more second connector ends CE21 and CE22, the first flexible portion F1, the second flexible portion F2, and/or the third flexible portion F3. The one or more first connector ends CE11 and CE12 may be electrically connected to at least one first element positioned in the first housing 11. The one or more second connector ends CE21 and CE22 may be electrically connected to at least one second element positioned in the second housing 12. The first flexible portion F1 may extend the one or more first connector ends CE11 and CE12 and the first rigid portion R1. The second flexible portion F2 may extend the one or more second connector ends CE21 and CE22 and the second rigid portion R2. The third flexible portion F3 may extend the first rigid portion R1 and the second rigid portion R2. The first fixing area 601 may include the first rigid portion R1, the first area F11 extending from the first rigid portion R1 of the first flexible portion F1, and the third area F31 extending from the first rigid portion R1 of the third flexible portion F3. The second fixing area 602 may include the second rigid portion R2, the second area F21 extending from the second rigid portion R2 of the second flexible portion F2, and the fourth area F32 extending from the second rigid portion R2 of the third flexible portion F3. The bendable area 603, which extends the third area F31 and the fourth area F32 of the third flexible portion F3, may be configured to be deformed in accordance with an angle between the first housing 11 and the second housing 12. The first rigid portion R1 may be disposed on the surface (e.g., the third surface 703) of the first support member 71 that is directed in the direction opposite to the surface facing the first plate 51. The second rigid portion R2 may be disposed on the surface of the second support member 72 that is directed in the direction opposite to the surface (e.g., the sixth surface 706) facing the second plate 52.

According to an example embodiment of the disclosure, the first support member 71 may include the first inclined surface (e.g., the first surface 701) configured to support the third area F31. The second support member 72 may include the second inclined surface (e.g., the fourth surface 704) configured to support the fourth area F32. The first inclined surface may define an obtuse angle with respect to the surface of the first support member 71 on which the first rigid portion R1 is disposed. The second inclined surface may define an obtuse angle with respect to the surface of the second support member 72 on which the second rigid portion R2 is disposed. The first angle between the first inclined surface and the first plate 51 may be equal to the second angle between the second inclined surface and the second plate 52.

According to an example embodiment of the disclosure, the first housing 11 may include the first support area 1111A, the third support area 1111B opposite to the first support area 1111A, and the first opening 401 configured to penetrate the first support area 1111A and the third support area 1111B. The second housing 12 may include the second support area 1211A, the fourth support area 1211B opposite to the second support area 1211A, and the second opening 402 configured to penetrate the second support area 1211A and the fourth support area 1211B. The first support area 1 111A and the second support area 1211A may face each other in the folded state of the foldable housing 10. In the unfolded state of the foldable housing 10, the first recess 1001 may be at least partially positioned between the second recess 1002 and the first opening 401. In the unfolded state of the foldable housing 10, the second recess 1002 may be at least partially positioned between the first recess 1001 and the second opening 402. The first flexible portion F1 of the flexible printed circuit board 6 may pass through the first opening 401. The second flexible portion F2 of the flexible printed circuit board 6 may pass through the second opening 402. The foldable electronic device may further include the first seal member 1310 disposed in the first opening 401, and the second seal member 1320 disposed in the second opening 402.

According to an example embodiment of the disclosure, the first opening 401 and the second opening 402 may be aligned with and overlap each other in the folded state of the foldable housing 10.

According to an example embodiment of the disclosure, the first support member 71 may include the third recess 1003 into which the first rigid portion R1 is inserted so that the first area F11 and the third area F31 may be tightly attached to the first support member 71. The second support member 72 may include the fourth recess into which the second rigid portion R2 is inserted so that the second area F21 and the fourth area F32 are tightly attached to the second support member 72.

According to an example embodiment of the disclosure, the foldable housing 10 may include the hinge housing 13 connected to the hinge portion 14 and configured to cover the hinge portion 14. The foldable housing 10 may be configured such that the hinge housing 13 is exposed to the outside of the foldable electronic device through a gap between the first housing 11 and the second housing 12 in the folded state of the foldable housing 10. In the folded state of the foldable housing 10, a width of the gap between the first housing 11 and the second housing 12 may vary depending on the angle between the first housing 11 and the second housing 12. The hinge portion 14 may include the hinge module (e.g., the first hinge module 141) operatively connected to the first plate 51 and the second plate 52. The hinge module may include the first bracket 1411 coupled to the first housing 11, the second bracket 1412 coupled to the second housing 12, and the bracket connection part 1413 configured to connect the first bracket 1411 and the second bracket 1412. The hinge housing 13 may be coupled to the bracket connection part 1413. The hinge housing 13 may include the recess (e.g., the fifth recess 1005) corresponding to the bendable area 603 of the flexible printed circuit board 6. In the unfolded state of the foldable housing 10, the recess of the hinge housing 13 may be positioned between the first recess 1001 and the second recess 1002. When the foldable housing 10 is changed from the unfolded state to the folded state, the bendable area 603 of the flexible printed circuit board 6 may be inserted into the recess of the hinge housing 13 and supported by the surface of the recess.

According to an example embodiment of the disclosure, in the unfolded state of the foldable housing 10, the bendable area 603 of the flexible printed circuit board 6 may be configured to be disposed in a shape having the first bending portion BP1 supported by the first plate 51, the second bending portion BP2 supported by the second plate 52, and the third and fourth bending portions BP3 and BP4 supported by the hinge housing 13.

According to an example embodiment of the disclosure, the foldable electronic device 1 may further include the first film 1410 disposed on the first plate 51, and the second film 1420 disposed on the second plate 52. The first film 1410 may be configured to be in contact with the third flexible portion F3 in the folded state and/or the unfolded state of the foldable housing 10. The second film 1420 may be configured to be in contact with the third flexible portion F3 in the folded state and/or the unfolded state of the foldable housing 10.

According to an example embodiment of the disclosure, the first end 511 of the first plate 51 and the second end 521 of the second plate 52 may face each other in the unfolded state of the foldable housing 10. The first end 511 and the second end 521 may be positioned to be further spaced apart from each other in the folded state of the foldable housing 10 than in the unfolded state of the foldable housing 10. The first end 511 may include the first curved surface 5111 configured to support the third flexible portion F3 in the folded state of the foldable housing 10. The second end 521 may include the second curved surface 5211 configured to support the third flexible portion F3 in the folded state of the foldable housing 10.

According to an exmaple embodiment of the disclosure, the foldable electronic device 1 may further include the third support member 81, the fourth support member 82, the fifth support member 91, and/or the sixth support member 92. The third support member 81 may be at least partially positioned between the first support member 71 and the first plate 51 and coupled to the first housing 11 in order to press the first support member 71 toward the first recess 1001. The fourth support member 82 may be at least partially positioned between the second support member 72 and the second plate 52 and coupled to the second housing 12 in order to press the second support member 72 toward the second recess 1002. The fifth support member 91 may be disposed on the third support member 81, inserted into the first opening 401, and configured to tightly attach the first flexible portion F1 to the surface of the first opening 401. The sixth support member 92 may be disposed on the fourth support member 82, inserted into the second opening 402, and configured to tightly attach the second flexible portion F2 to the surface of the second opening 402.

According to an exmaple embodiment of the disclosure, the first seal member 1310 and/or the second seal member 1320 may be formed by curing an adhesive material. The fifth support member 91 may be configured such that the adhesive material does not leak through the first opening 401. The sixth support member 92 may be configured such that the adhesive material does not leak through the second opening 402.

According to an exmaple embodiment of the disclosure, the foldable electronic device 1 may include the foldable housing 10, the flexible display module (e.g., the first display module 15), the flexible printed circuit board 6, the first support member 71, and/or the second support member 72. The foldable housing 10 may include the first housing 11, the second housing 12, and the hinge portion 14 configured to connect the first housing 11 and the second housing 12. The flexible display module may be disposed in the foldable housing 10. The flexible display module may include the first display area 151 disposed in the first housing 11, the second display area 152 disposed in the second housing 12, and the third display area 153 configured to extend the first display area 151 and the second display area 152. In the folded state of the foldable housing 10, the first display area 151 and the second display area 152 may face each other, and the third display area 153 may be curved. The flexible printed circuit board 6 may extend across the hinge portion 14. The first support member 71 may be configured to connect the flexible printed circuit board 6 to the first housing 11. The second support member 72 may be configured to connect the flexible printed circuit board 6 to the second housing 12. The hinge portion 14 may include the first plate 51 and the second plate 52. The hinge portion 14 may be configured such that the first plate 51 and the second plate 52 support the third display area 153 so that the third display area 153 is flat in the unfolded state of the foldable housing 10. The hinge portion 14 may be configured such that the first plate 51 and the second plate 52 face each other with the third display area 153 interposed therebetween in the folded state of the foldable housing 10. The first support member 71 may be positioned between the first plate 51 and the first housing 11 and disposed in the first recess 1001 formed on the first housing 11. The first fixing area 601 of the flexible printed circuit board 6 may be disposed between the first support member 71 and the first housing 11 and surround the first support member 71 in the first recess 1001. The second support member 72 may be positioned between the second plate 52 and the second housing 12 and disposed in the second recess 1002 formed on the second housing 12. The second fixing area 602 of the flexible printed circuit board 6 may be disposed between the second support member 72 and the second housing 12 and surround the second support member 72 in the second recess 1002.

According to an example embodiment of the disclosure, the flexible display module (e.g., the first display module 15) may be disposed to be flat in the first direction in the unfolded state of the foldable housing 10 when viewed in the direction of the folding axis (e.g., the centerline A) of the foldable housing 10. The hinge portion 14 may be configured such that the first plate 51 and the second plate 52 defines an acute angle in the second direction, which is perpendicular to the first direction and directed from the first display area 151 and the second display area 152 toward the third display area 153, in the unfolded state of the foldable housing 10 when viewed in the direction of the folding axis. The space between the first plate 51 and the second plate 52 may increase in the second direction.

According to an example embodiment of the disclosure, the flexible printed circuit board 6 may include the first rigid portion R1, the second rigid portion R2, the one or more first connector ends CE11 and CE12, the one or more second connector ends CE21 and CE22, the first flexible portion F1, the second flexible portion F2, and/or the third flexible portion F3. The one or more first connector ends CE11 and CE12 may be electrically connected to at least one first element positioned in the first housing 11. The one or more second connector ends CE21 and CE22 may be electrically connected to at least one second element positioned in the second housing 12. The first flexible portion F1 may extend the one or more first connector ends CE11 and CE12 and the first rigid portion R1. The second flexible portion F2 may extend the one or more second connector ends CE21 and CE22 and the second rigid portion R2. The third flexible portion F3 may extend the first rigid portion R1 and the second rigid portion R2. The first fixing area 601 may include the first rigid portion R1, the first area F11 extending from the first rigid portion R1 of the first flexible portion F1, and the third area F31 extending from the first rigid portion R1 of the third flexible portion F3. The second fixing area 602 may include the second rigid portion R2, the second area F21 extending from the second rigid portion R2 of the second flexible portion F2, and the fourth area F32 extending from the second rigid portion R2 of the third flexible portion F3. The bendable area 603, which extends the third area F31 and the fourth area F32 of the third flexible portion F3, may be configured to be deformed in accordance with an angle between the first housing 11 and the second housing 12. The first rigid portion R1 may be disposed on the surface (e.g., the third surface 703) of the first support member 71 that is directed in the direction opposite to the surface facing the first plate 51. The second rigid portion R2 may be disposed on the surface (e.g., the sixth surface 706) of the second support member 72 that is directed in the direction opposite to the surface facing the second plate 52.

According to an example embodiment of the disclosure, the first housing 11 may include the first support area 1111A, the third support area 1111B opposite to the first support area 1111A, and the first opening 401 configured to penetrate the first support area 1111A and the third support area 1111B. The second housing 12 may include the second support area 1211A, the fourth support area 1211B opposite to the second support area 1211A, and the second opening 402 configured to penetrate the second support area 1211A and the fourth support area 1211B. The first support area 1111A and the second support area 1211A may face each other in the folded state of the foldable housing 10. In the folded state of the foldable housing 10, the first recess 1001 may be at least partially positioned between the second recess 1002 and the first opening 401. In the folded state of the foldable housing 10, the second recess 1002 may be at least partially positioned between the first recess 1001 and the second opening 402. The first flexible portion F1 of the flexible printed circuit board 6 may pass through the first opening 401. The second flexible portion F2 of the flexible printed circuit board 6 may pass through the second opening 402. The foldable electronic device may further include the first seal member 1310 disposed in the first opening 401, and the second seal member 1320 disposed in the second opening 402.

According to an example embodiment of the disclosure, the foldable electronic device 1 may further include the third support member 81, the fourth support member 82, the fifth support member 91, the sixth support member 92, the first seal member 1310, and/or the second seal member 1320. The third support member 81 may be at least partially positioned between the first support member 71 and the first plate 51 and coupled to the first housing 11 in order to press the first support member 71 toward the first recess 1001. The fourth support member 82 may be at least partially positioned between the second support member 72 and the second plate 52 and coupled to the second housing 12 in order to press the second support member 72 toward the second recess 1002. The fifth support member 91 may be disposed on the third support member 81, inserted into the first opening 401, and configured to tightly attach the first flexible portion F1 to the surface of the first opening 401. The sixth support member 92 may be disposed on the fourth support member 82, inserted into the second opening 402, and configured to tightly attach the second flexible portion F2 to the surface of the second opening 402. The first seal member 1310 and/or the second seal member 1320 may be formed by curing an adhesive material. The fifth support member 91 may be configured such that the adhesive material does not leak through the first opening 401. The sixth support member 92 may be configured such that the adhesive material does not leak through the second opening 402.

The embodiments of the disclosure disclosed in the disclosure and illustrated in the drawings are provided as particular examples for more easily explaining the technical contents according to the disclosure and helping understand the disclosure, but not intended to limit the scope of the disclosure. Accordingly, the scope of the various embodiments of the disclosure should be interpreted as including alterations or modifications in addition to the disclosed embodiments. Additionally, it will be understood that any embodiment(s) described herein may be used in conjunction with any other embodiment(s) described herein. In particular, while the disclosure has been presented in the form of providing the plurality of embodiments respectively defining the plurality of features, it is emphasized that some of these embodiments are connected only by reference to the same drawing or drawings. The disclosure needs to be understood as including all the combinations of these embodiments as long as there is no apparent contradiction between the two (or more) embodiments. That is, in case that the features are presented as optional in the disclosure, all the combinations of the optional features are included in the disclosure.

## Claims

1. A foldable electronic device (1) comprising:
a foldable housing (10) comprising a first housing (11), a second housing (12), and a hinge portion (14) configured to connect the first housing (11) and the second housing (12);
a flexible printed circuit board (6) extending across the hinge portion (14);
a first support member (71) configured to connect the flexible printed circuit board (6) to the first housing (11); and
a second support member (72) configured to connect the flexible printed circuit board (6) to the second housing (12),
wherein the hinge portion (14) comprises a first plate (51) and a second plate (52),
wherein the hinge portion (14) is configured such that the first plate (51) and the second plate (52) face each other when the foldable housing (10) is changed from an unfolded state to a folded state,
wherein the first support member (71) is positioned between the first plate (51) and the first housing (11) and is disposed in a first recess (1001) formed on the first housing (11),
wherein a first fixing area (601) of the flexible printed circuit board (6) is disposed between the first support member (71) and the first housing (11) to surround the first support member (71) in the first recess (1001),
wherein the second support member (72) is positioned between the second plate (52) and the second housing (12) and is disposed in a second recess (1002) formed on the second housing (12), and
wherein a second fixing area (602) of the flexible printed circuit board (6) is disposed between the second support member (72) and the second housing (12) to surround the second support member (72) in the second recess (1002).

2. The foldable electronic device of claim 1, further comprising a flexible display module (15) disposed on the foldable housing (10), the flexible display module (15) comprising a first display area (151) disposed on the first housing (11), a second display area (152) disposed on the second housing (12), and a third display area (153) extending the first display area (151) and the second display area (152),
wherein the first display area (151) and the second display area (152) face each other and the third display area (153) is bent in the folded state of the foldable housing (10),
wherein the hinge portion (14) is configured such that the first plate (51) and the second plate (52) support the third display area (153) to be flat in the unfolded state of the foldable housing (10), and
wherein the hinge portion (14) is configured such that the first plate (51) and the second plate (52) face each other with the third display area (153) interposed therebetween in the folded state of the foldable housing (10).

3. The foldable electronic device of claim 2,
wherein, when viewed in a direction of a folding axis (A) of the foldable housing (10) in the unfolded state of the foldable housing (10), the flexible display module (15) is disposed to be flat in a first direction, and
wherein, when viewed in the direction of the folding axis (A) of the foldable housing (10) in the unfolded state of the foldable housing (10), the hinge portion (14) is configured such that the first plate (51) and the second plate (52) is at an acute angle to a second direction perpendicular to the first direction from the first and second display areas (151, 152) toward the third display area (153), and
wherein a space between the first plate (51) and the second plate (52) increases in the second direction.

4. The foldable electronic device of any one of claims 1 to 3, wherein the first recess (1001) and the second recess (1002) are aligned with and overlap each other in the folded state of the foldable housing (10).

5. The foldable electronic device of any one of claims 1 to 4,
wherein the flexible printed circuit board (6) comprises:
a first rigid portion (R1),
a second rigid portion (R2),
one or more first connector ends (CE11, CE12) electrically connected to at least one first element positioned in the first housing (11),
one or more second connector ends (CE21, CE22) electrically connected to at least one second element positioned in the second housing (12),
a first flexible portion (F1) extending the one or more first connector ends (CE11, CE12) and the first rigid portion (R1),
a second flexible portion (F2) extending the one or more second connector ends (CE21, CE22) and the second rigid portion (R2), and
a third flexible portion (F3) extending the first rigid portion (R1) and the second rigid portion (R2),
wherein the first fixing area (601) comprises the first rigid portion (R1), a first area (F11) of the first flexible portion (F1) extending from the first rigid portion (R1), and a third area (F31) of the third flexible portion (F3) extending from the first rigid portion (R1),
wherein the second fixing area (602) comprises the second rigid portion (R2), a second area (F21) of the second flexible portion (F2) extending from the second rigid portion (R2), and a fourth area (F32) of the third flexible portion (F3) extending from the second rigid portion (R2),
wherein a bendable area (603) of the third flexible portion (F3) extending the third area (F31) and the fourth area (F32) is configured to be transformed according to an angle between the first housing (11) and the second housing (12),
wherein the first rigid portion (R1) is disposed on a surface (703) of the first support member (71) opposite to a surface of the first support member (71) facing the first plate (51), and
wherein the second rigid portion (R2) is disposed on a surface (706) of the second support member (72) opposite to a surface of the second support member (72) facing the second plate (52).

6. The foldable electronic device of claim 5,
wherein the first support member (71) comprises a first inclined surface (701) configured to support the third area (F31),
wherein the second support member (72) comprises a second inclined surface (704) configured to support the fourth area (F32),
wherein the first inclined surface (701) is at an obtuse angle to the surface of the first support member (71) where the first rigid portion (R1) is disposed,
wherein the second inclined surface (704) is at an obtuse angle to the surface of the second support member (72) where the second rigid portion (R2) is disposed, and
wherein a first angle between the first inclined surface (701) and the first plate (51) is identical to a second angle between the second inclined surface (704) and the second plate (52).

7. The foldable electronic device of claim 5,
wherein the first housing (11) comprises a first support area (1111A), a third support area (1111B) opposite to the first support area (1111A), and a first opening (401) penetrating between the first support area (1111A) and the third support area (1111B),
wherein the second housing (12) comprises a second support area (1211A), a fourth support area (1211B) opposite to the second support area (1211A), and a second opening (402) penetrating between the second support area (1211A) and the fourth support area (1211B),
wherein the first support area (1111A) and the second support area (1211A) face each other in the folded state of the foldable housing (10),
wherein the first recess (1001) is at least partially positioned between the second recess (1002) and the first opening (401) in the unfolded state of the foldable housing (10),
wherein the second recess (1002) is at least partially positioned between the first recess (1001) and the second opening (402) in the unfolded state of the foldable housing (10),
wherein the first flexible portion (F1) of the flexible printed circuit board (6) passes through the first opening (401),
wherein the second flexible portion (F2) of the flexible printed circuit board (6) passes through the second opening (402), and
wherein the foldable electronic device further comprises a first seal member (1310) disposed in the first opening (401) and a second seal member (1320) disposed in the second opening (402).

8. The foldable electronic device of claim 7, wherein the first opening (401) and the second opening (402) are aligned with and overlap each other in the folded state of the foldable housing (10).

9. The foldable electronic device of any one of claims 5 to 8,
wherein the first support member (71) comprises a third recess (1003) configured such that the first rigid portion (R1) is inserted therein such that the first area (F11) and the third area (F31) are tight on the first support member (71), and
wherein the second support member (72) comprises a fourth recess configured such that the second rigid portion (R2) is inserted therein such that the second area (F21) and the fourth area (F32) are tight on the second support member (72).

10. The foldable electronic device of any one of claims 5 to 9,
wherein the foldable housing (10) comprises a hinge housing (13) connected to the hinge portion (14) and configured to cover the hinge portion (14),
wherein the foldable housing (10) is configured such that the hinge housing (12) is exposed to an outside of the foldable electronic device via a gap between the first housing (11) and the second housing (12) in the folded state of the foldable housing (10),
wherein a width of the gap between the first housing (11) and the second housing (12) varies depending on an angle between the first housing (11) and the second housing (12) in the folded state of the foldable housing (10),
wherein the hinge portion (14) comprises a hinge module (141) operatively connected to the first and second plates (51, 52),
wherein the hinge module (141) comprises a first bracket (1411) coupled to the first housing (11), a second bracket (1412) coupled to the second housing (12), and a bracket connection part (1413) connecting the first bracket (1411) and the second bracket (1412),
wherein the hinge housing (13) is coupled to the bracket connection part (1413),
wherein the hinge housing (13) comprises a recess (1005) corresponding to the bendable area (603) of the flexible printed circuit board (6),
wherein the recess (1005) of the hinge housing (13) is positioned between the first recess (1001) and the second recess (1002) in the unfolded state of the foldable housing (10), and
wherein, when the foldable housing is changed from the unfolded state to the folded state, the bendable area (603) of the flexible printed circuit board (6) is inserted into the recess (1005) of the hinge housing (13) to be supported by a surface of the recess (1005) of the hinge housing (13).

11. The foldable electronic device of claim 10,
wherein the bendable area (603) of the flexible printed circuit board (6) is configured to be disposed in a shape having a first bending portion (BP1) supported by the first plate (51), a second bending portion (BP2) supported by the second plate (52), and third and fourth bending portions (BP3, BP4) supported by the hinge housing (13) in the unfolded state of the foldable housing (10).

12. The foldable electronic device of any one of claims 5 to 11, further comprising:
a first film (1410) disposed on the first plate (51) and configured to be in contact with the third flexible portion (F3) in the folded state and/or the unfolded state of the foldable housing (10); and
a second film (1420) disposed on the second plate (52) and configured to be in contact with the third flexible portion (F3) in the folded state and/or the unfolded state of the foldable housing (10).

13. The foldable electronic device of any one of claims 5 to 12,
wherein a first end (511) of the first plate (51) and a second end (521) of the second plate (52) face each other in the unfolded state of the foldable housing (10),
wherein the first end (511) and the second end (521) are positioned to be more spaced apart from each other in the folded state of the foldable housing (10) than in the unfolded state of the foldable housing (10),
wherein the first end (511) comprises a first curved surface (5111) configured to support the third flexible portion (F3) in the folded state of the foldable housing (10), and
wherein the second end (521) comprises a second curved surface (5211) configured to support the third flexible portion (F3) in the folded state of the foldable housing (10).

14. The foldable electronic device of any one of claims 7 to 13, further comprising:
a third support member (81) at least partially positioned between the first support member (71) and the first plate (51) and coupled to the first housing (11) to press the first support member (71) toward the first recess (1001);
a fourth support member (82) at least partially positioned between the second support member (72) and the second plate (52) and coupled to the second housing (12) to press the second support member (72) toward the second recess (1002);
a fifth support member (91) disposed on the third support member (81) and inserted into the first opening (401) such that the first flexible portion (F1) is tight on a surface of the first opening (401); and
a sixth support member (92) disposed on the fourth support member (82) and inserted into the second opening (402) such that the second flexible portion (F2) is tight on a surface of the second opening (402).

15. The foldable electronic device of claim 14,
wherein the first seal member (1310) and/or the second seal member (1320) are formed by curing an adhesive material,
wherein the fifth support member (91) is configured such that the adhesive material is not leaked through the first opening (401), and
wherein the sixth support member (92) is configured such that the adhesive material is not leaked through the second opening (402).
